# EUROPEAN PATENT SPECIFICATION

(11) **EP 4 496 217 B1**
(45) Date of publication and mention of the grant of the patent: **08.04.2026**
(21) Application number: 22938538.0
(22) Date of filing: 22.04.2022
(51) Int. Cl.: H03F 1/02, H03F 3/68, H03F 1/56, H03F 3/195, H03F 3/60, H03F 3/24

(54) **DOHERTY AMPLIFIER**
DOHERTY-VERSTÄRKER
AMPLIFICATEUR DOHERTY

(43) Date of publication of application: 22.01.2025
(73) Proprietor: MITSUBISHI ELECTRIC CORPORATION, Chiyoda-ku Tokyo 100-8310 (JP)
(72) Inventor: KOMATSUZAKI, Yuji, Tokyo 100-8310 (JP); TORII, Takuma, Tokyo 100-8310 (JP)
(74) Representative: Pfenning, Meinig & Partner mbB
(86) International application number: PCT/JP2022/018499
(87) International publication number: WO 2023/203738

(56) References cited:
- WO-A1-2020/217422
- JP-A- 2012 034 134
- JP-A- 2013 519 307
- JP-A- 2015 019 275
- US-A1- 2016 241 201
- US-A1- 2016 241 201
- US-A1- 2020 244 227
- US-B1- 9 634 615

## Description

### TECHNICAL FIELD

The present disclosure relates to a Doherty amplifier.

### BACKGROUND ART

In recent years, in response to a dramatic increase in an amount of communication, for example, a fifth generation mobile communication base station amplifier is required to be capable of amplifying a signal having a peak to average power ratio (PAPR) of equal to or more than 6 dB with high efficiency and to operate in a wide band corresponding to a plurality of bands from a viewpoint of downsizing and cost reduction of the base station. A Doherty amplifier has been proposed as an amplifier that amplifies a communication signal with high efficiency. The Doherty amplifier performs load modulation by connecting two amplifiers of a carrier amplifier and a peaking amplifier in parallel and loading a 90 degree line on an output side of the carrier amplifier, and implements a highly-efficiency operation at a backoff operation point where output power is lower than saturation output.

However, a general Doherty amplifier can cope with only a signal having a PAPR of about 6 dB in operation principle, and operates with low efficiency for a signal having a PAPR significantly exceeding 6 dB, for example, a signal having a PAPR of 10 dB.

On the other hand, Patent Literature 1 discloses a Doherty amplifier including a second peaking amplifier in addition to a carrier amplifier and a peaking amplifier.

Specifically, in the Doherty amplifier of Patent Literature 1, one of three amplifiers operates as a carrier amplifier, one of the remaining two operates as a first peaking amplifier, and the remaining one operates as a second peaking amplifier at a certain center frequency, and the peaking amplifier has two stages with respect to power, thereby expanding a range of load modulation of the carrier amplifier to equal to or more than 6 dB and improving efficiency for a PAPR signal of equal to or more than 6 dB.

Patent Literature 2 discloses a power amplifier comprising a first, second and third sub-amplifier for amplification of an input signal into an output signal. The sub-amplifiers are connected to an input network and an output network. The output network comprises a first, second and third transmission line connected to the first, second and third sub-amplifier, respectively. A difference in electrical length between the first, second and third transmission lines is an integer number of quarter-wavelengths of a center frequency of the power amplifier. A first, second and third electrical length includes the first, second and third transmission line, respectively. A longest one of the electrical lengths is at least a multiple of quarter-wavelengths of the center frequency.

Patent Literature 3 discloses a Doherty amplifier device operable over multiple frequency bands includes a controller that, in some embodiments, that is configured to output a carrier bias signal to a first amplifier and a peaking bias signal to a second amplifier as part of a first operating configuration associated with a first frequency band, and output the peaking bias signal to the second amplifier and the carrier bias signal to a third amplifier as part of a second operating configuration associated with a second frequency band.

Patent Literature 4 discloses a compensation circuit having one end connected to another end of a first output circuit and another end of a second output circuit and another end grounded, the compensation circuit having an electrical length of 90 degrees at a first operation frequency and an electrical length of 45 degrees at a second operation frequency which is half of the first operation frequency.

### CITATION LIST

### PATENT LITERATURES

Patent Literature 1: JP 2011-507445 W
Patent Literature 2: US 2016/241201 A1
Patent Literature 3: US 9 634 615 B1
Patent Literature 4: US 2020/244227 A1

### SUMMARY OF INVENTION

### TECHNICAL PROBLEM

However, in the Doherty amplifier of Patent Literature 1, the load modulation is established only at the center frequency, and as a result, a role of each amplifier is fixed, and a high-efficiency operation at the time of backoff is established only near the center frequency. For this reason, there is a problem that a wide band cannot be achieved.

The present disclosure has been made to solve the above problem, and an object thereof is to provide a Doherty amplifier that operates with high efficiency in a wide band even at the time of backoff exceeding 6 dB.

### SOLUTION TO PROBLEM

In a Doherty amplifier according to the present disclosure, the number of amplifiers contributing to an amplification operation changes depending on power of an input signal, the Doherty amplifier including at least four or more amplifiers; and a combining circuit to combine outputs of the amplifiers, wherein the amplifiers are connected in parallel with each other, the amplifiers include a first amplifier, a second amplifier, a third amplifier, and a fourth amplifier, order in which the amplifiers contribute to the amplification operation differs depending on a frequency of the input signal, the combining circuit includes: a first output circuit connected to an output terminal of the first amplifier and having an electrical length of 90 degrees at a center frequency; a second output circuit connected to an output terminal of the second amplifier and having an electrical length of 180 degrees at a center frequency; a third output circuit connected to an output terminal of the third amplifier and having an electrical length of 90 degrees at a center frequency; and a fourth output circuit connected to an output terminal of the fourth amplifier and having an electrical length of 180 degrees at a center frequency, the amplification operation is performed in such a manner that: at a center frequency, the third amplifier operates when the input signal has low power, the first amplifier joins the operation when the input signal has medium power, and the second amplifier and the fourth amplifier join the operation when the input signal has high power, in a first frequency group, the first amplifier operates when the input signal has low power, the third amplifier joins the operation when the input signal has medium power, and the second amplifier and the fourth amplifier join the operation when the input signal has high power, in a second frequency group, the second amplifier operates when the input signal has low power, the fourth amplifier joins the operation when the input signal has medium power, and the first amplifier and the third amplifier join the operation when the input signal has high power, and in a third frequency group, the fourth amplifier operates when the input signal has low power, the second amplifier joins the operation when the input signal has medium power, and the first amplifier and the third amplifier join the operation when the input signal has high power.

### ADVANTAGEOUS EFFECTS OF INVENTION

According to the present disclosure, it is possible to provide a Doherty amplifier that operates with high efficiency in a wide band even at the time of backoff exceeding 6 dB.

### BRIEF DESCRIPTION OF DRAWINGS

FIG. 1 is a diagram illustrating a configuration of a Doherty amplifier according to a first embodiment of the present disclosure.
FIG. 2 is a diagram illustrating configurations of a first amplifier, a first output circuit, a third amplifier, and a third output circuit of the Doherty amplifier according to the first embodiment of the present disclosure.
FIG. 3 is a diagram illustrating configurations of a second amplifier, a second output circuit, a fourth amplifier, and a fourth output circuit of the Doherty amplifier according to the first embodiment of the present disclosure.
FIG. 4 is a diagram illustrating a concept of a configuration of a Doherty amplifier according to the present disclosure.
FIG. 5 is a diagram illustrating transformation of a load in a low power region of the amplifier according to the first embodiment of the present disclosure.
FIG. 6 is a diagram illustrating transformation of a load in a medium power region of the amplifier according to the first embodiment of the present disclosure.
FIG. 7 is a diagram illustrating transformation of a load in a high power region of the amplifier according to the first embodiment of the present disclosure.
FIG. 8 is a table illustrating a relationship between a frequency and amplifiers that perform an amplification operation in an operation power region in the Doherty amplifier according to the present disclosure.
FIG. 9 is a diagram illustrating a configuration of a Doherty amplifier according to a second embodiment of the present disclosure.
FIG. 10 is a diagram illustrating a configuration of each amplifier of a Doherty amplifier according to a third embodiment of the present disclosure.
FIG. 11 is a diagram illustrating a configuration of each amplifier of a Doherty amplifier according to a fourth embodiment of the present disclosure.
FIG. 12 is a diagram illustrating a configuration of each amplifier of a Doherty amplifier according to a sixth embodiment of the present disclosure.
FIG. 13 is a diagram illustrating a configuration of each amplifier of a Doherty amplifier according to a seventh embodiment of the present disclosure.

### DESCRIPTION OF EMBODIMENTS

Hereinafter, in order to explain the present disclosure in more detail, embodiments for carrying out the present disclosure will be described with reference to the accompanying drawings.

### First Embodiment.

A configuration example of a Doherty amplifier according to the present disclosure will be described.

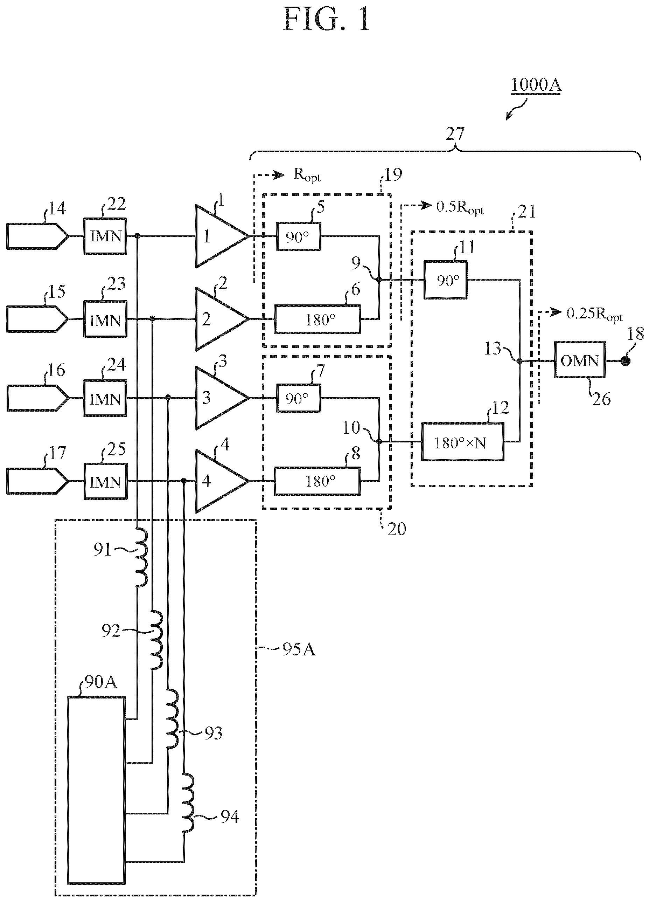

FIG. 1 is a diagram illustrating a configuration of a Doherty amplifier 1000A according to a first embodiment of the present disclosure.

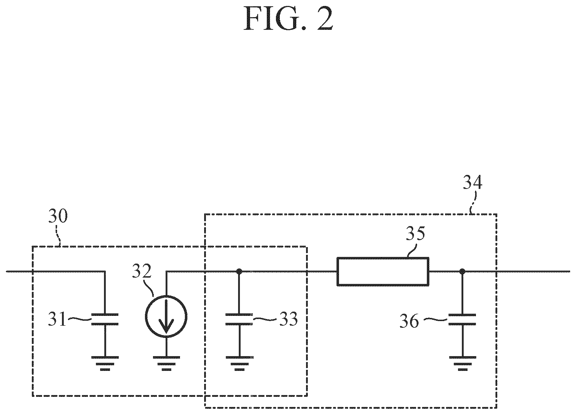

FIG. 2 is a diagram illustrating configurations of a first amplifier, a first output circuit, a third amplifier, and a third output circuit of the Doherty amplifier 1000A according to the first embodiment of the present disclosure.

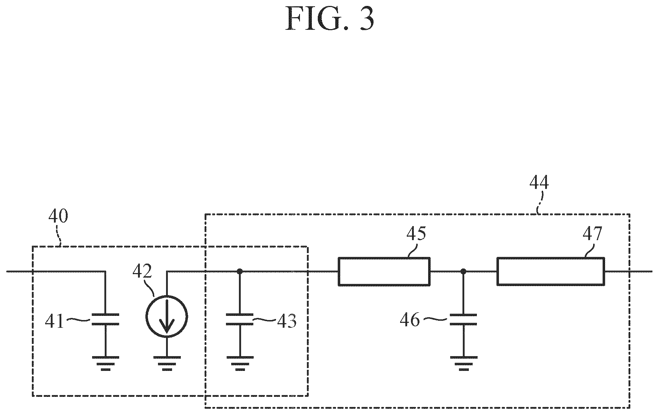

FIG. 3 is a diagram illustrating configurations of a second amplifier, a second output circuit, a fourth amplifier, and a fourth output circuit of the Doherty amplifier 1000A according to the first embodiment of the present disclosure.

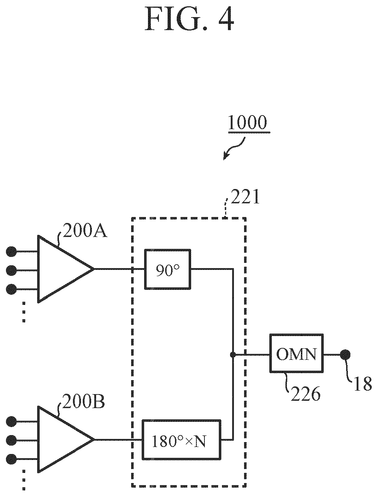

FIG. 4 is a diagram illustrating a concept of a configuration of a Doherty amplifier 1000 according to the present disclosure.

The Doherty amplifier 1000A according to the present disclosure is a Doherty amplifier in which the number of amplifiers contributing to an amplification operation changes depending on power of an input signal.

The Doherty amplifier 1000A includes at least four or more amplifiers.

Note that, in the drawing, the Doherty amplifier 1000A includes four amplifiers, but the number of amplifiers is not limited to the illustrated number.

In the Doherty amplifier 1000A, the amplifiers are configured in such a manner that order of contribution to the amplification operation varies depending on a frequency of the input signal.

The Doherty amplifier 1000A further includes a combining circuit 27.

The combining circuit 27 combines outputs of the amplifiers.

The combining circuit 27 is a combining circuit of a tournament-type that stepwisely combines outputs of amplifiers. In addition, the combining circuit 27 is a circuit having an asymmetric configuration as viewed from each combining point.

Specifically, the combining circuit 27 illustrated in FIG. 1 is, for example, a combining circuit of a tournament type that stepwisely combines outputs of four amplifiers two by two. In addition, the combining circuit 27 is a circuit having an asymmetric configuration as viewed from each combining point that combines two outputs.

By such a combining circuit 27, in the Doherty amplifier according to the present disclosure, it is possible to cause load modulation depending on the number of amplifiers to be activated among the amplifiers.

In detailed description of the circuit to be described later, a Doherty amplifier including four amplifiers will be described as a representative. In a case of more than four amplifiers, the Doherty amplifier according to the present disclosure can be implemented by applying a concept similar to the concept in the case of four amplifiers and by including a combining circuit of a tournament type that stepwisely combines outputs of amplifiers, the combining circuit having an asymmetric configuration as viewed from each combining point.

In a case where the amplifiers in the Doherty amplifier 1000A are constituted by four amplifiers, the amplifiers are constituted by a first amplifier 1, a second amplifier 2, a third amplifier 3, and a fourth amplifier 4 as illustrated in the drawing.

The Doherty amplifier 1000A has a circuit configuration in which the number of amplifiers to be operated changes depending on a power level of the input signal.

In the Doherty amplifier 1000A, the number of amplifiers to be operated changes depending on the power level of at least three stages such as low power, medium power, and high power of the power of the input signal.

In the Doherty amplifier 1000A illustrated in the drawing, one amplifier among the amplifiers operates in a case where the input signal has low power.

In the Doherty amplifier 1000A illustrated in the drawing, two amplifiers among the amplifiers operate in a case where the input signal has medium power.

In the Doherty amplifier 1000A illustrated in the drawing, four amplifiers, which are all the amplifiers, operate in a case where the input signal has high power.

The Doherty amplifier 1000A according to the first embodiment will be described in detail.

The Doherty amplifier 1000A illustrated in FIG. 1 includes a first signal source 14, a first input matching circuit (IMN) 22, the first amplifier 1, a second signal source 15, a second input matching circuit (IMN) 23, the second amplifier 2, a third signal source 16, a third input matching circuit (IMN) 24, the third amplifier 3, a fourth signal source 17, a fourth input matching circuit (IMN) 25, the fourth amplifier 4, a first small branch combining circuit 19, a second small branch combining circuit 20, a large branch combining circuit 21, an output matching circuit 26, and an output terminal 18.

The combining circuit 27 in the Doherty amplifier 1000A illustrated in FIG. 1 includes the first small branch combining circuit 19, the second small branch combining circuit 20, the large branch combining circuit 21, and the output matching circuit 26.

The first small branch combining circuit 19 bundles and outputs an output of the first amplifier and an output of the second amplifier.

The second small branch combining circuit 20 bundles and outputs an output of the third amplifier and an output of the fourth amplifier.

The large branch combining circuit 21 bundles and outputs an output of the first small branch combining circuit and an output of the second small branch combining circuit.

The first small branch combining circuit 19 includes a first output circuit 5 and a second output circuit 6, and the first output circuit 5 and the second output circuit 6 are connected at a combining point 9 of the first small branch combining circuit. The second small branch combining circuit 20 includes a third output circuit 7 and a fourth output circuit 8, and the third output circuit 7 and the fourth output circuit 8 are connected at a combining point 10 of the second small branch combining circuit. The large branch combining circuit 21 includes a fifth output circuit 11 and a sixth output circuit 12, and the fifth output circuit 11 and the sixth output circuit 12 are connected at a combining point 13 of the large branch combining circuit.

The first signal source 14 is a signal source that generates an input signal of the first amplifier 1 via the first input matching circuit 22. The second signal source 15 is a signal source that generates an input signal of the second amplifier 2 via the second input matching circuit 23. The third signal source 16 is a signal source that generates an input signal of the third amplifier 3 via the third input matching circuit 24. The fourth signal source 17 is a signal source that generates an input signal of the fourth amplifier 4 via the fourth input matching circuit 25. As the first signal source 14, the second signal source 15, the third signal source 16, and the fourth signal source 17, for example, a quadrature modulator, a digital analog converter (DAC), a direct digital synthesizer (DDS), or the like is used.

That is, a plurality of signal sources such as the first signal source 14, the second signal source 15, the third signal source 16, and the fourth signal source 17 is connected for different amplifiers.

The first signal source 14, the second signal source 15, the third signal source 16, and the fourth signal source 17 are synchronized, and a relationship of amplitude of an input signal with respect to output power of all the amplifiers and an operation mode can be controlled.

The first input matching circuit 22 is a matching circuit that performs input matching of the first amplifier 1. The first input matching circuit 22 is connected to the first signal source 14 and the first amplifier 1. For the first input matching circuit 22, for example, a circuit using a lumped constant element, a circuit using a distributed constant line, a circuit combining a lumped constant and a distributed constant, an L-C type matching circuit, a λ/4 line, or the like is used.

The first amplifier 1 is an amplifier that amplifies an input signal output from the first input matching circuit 22. An input terminal of the first amplifier 1 is connected to the first input matching circuit 22, and an output terminal of the first amplifier 1 is connected to the first output circuit 5. For a transistor of the first amplifier 1, for example, a field effect transistor (FET), a hetero-junction bipolar transistor (HBT), a high electron mobility transistor (HEMT), or the like is used. More specifically, the first amplifier 1 corresponds to an amplifier 30 illustrated in FIG. 2 and includes an input capacitance 31, a current source 32, and an output capacitance 33 as an example, but is not limited to these configurations.

The first output circuit 5 is a circuit that modulates an output load of the first amplifier 1 to the current source 32. An input of the first output circuit 5 is connected to the output terminal of the first amplifier 1, and an output of the first output circuit 5 is connected to the combining point 9 of the first small branch combining circuit. More specifically, the first output circuit 5 corresponds to an output circuit 34 illustrated in FIG. 2 and includes the output capacitance 33 of the first amplifier 1, an output line 35, and a capacitance 36, but is not limited to these configurations.

The second input matching circuit 23 is a matching circuit that performs input matching of the second amplifier 2. The second input matching circuit 23 is connected to the second signal source 15 and the second amplifier 2. For the second input matching circuit 23, for example, a circuit using a lumped constant element, a circuit using a distributed constant line, a circuit combining a lumped constant and a distributed constant, an L-C type matching circuit, a λ/4 line, or the like is used.

The second amplifier 2 is an amplifier that amplifies an input signal output from the second input matching circuit 23. An input terminal of the second amplifier 2 is connected to the second input matching circuit 23, and an output terminal of the second amplifier 2 is connected to the second output circuit 6. For example, an FET, an HBT, an HEMT, or the like is used for a transistor of the second amplifier 2. More specifically, the second amplifier 2 corresponds to an amplifier 40 illustrated in FIG. 3 and includes, as an example, an input capacitance 41, a current source 42, and an output capacitance 43, but is not limited to these configurations.

The second output circuit 6 is a circuit that modulates an output load of the second amplifier 2 to the current source 42. An input of the second output circuit 6 is connected to the output terminal of the second amplifier 2, and an output of the second output circuit 6 is connected to the combining point 9 of the first small branch combining circuit. More specifically, the second output circuit 6 corresponds to an output circuit 44 illustrated in FIG. 3 and includes the output capacitance 43 of the second amplifier 2, an output line 45, a capacitance 46, and an output line 47, but is not limited to these configurations.

The third input matching circuit 24 is a matching circuit that performs input matching of the third amplifier 3. The third input matching circuit 24 is connected to the third signal source 16 and the third amplifier 3. For the third input matching circuit 24, for example, a circuit using a lumped constant element, a circuit using a distributed constant line, a circuit combining a lumped constant and a distributed constant, an L-C type matching circuit, a λ/4 line, or the like is used.

The third amplifier 3 is an amplifier that amplifies an input signal output from the third input matching circuit 24. An input terminal of the third amplifier 3 is connected to the third input matching circuit 24, and an output terminal of the third amplifier 3 is connected to the third output circuit 7. For a transistor of the third amplifier 3, for example, an FET, an HBT, an HEMT, or the like is used. More specifically, the third amplifier 3 corresponds to the amplifier 30 illustrated in FIG. 2 and includes the input capacitance 31, the current source 32, and the output capacitance 33 as an example, but is not limited to these configurations.

The third output circuit 7 is a circuit that modulates an output load of the third amplifier 3 to the current source 32. An input of the third output circuit 7 is connected to the output terminal of the third amplifier 3, and an output of the third output circuit 7 is connected to the combining point 10 of the second small branch combining circuit. More specifically, the third output circuit 7 corresponds to the output circuit 34 illustrated in FIG. 2 and includes the output capacitance 33 of the third amplifier 3, the output line 35, and the capacitance 36, but is not limited to these configurations.

The fourth input matching circuit 25 is a matching circuit that performs input matching of the fourth amplifier 4. The fourth input matching circuit 25 is connected to the fourth signal source 17 and the fourth amplifier 4. For the fourth input matching circuit 25, for example, a circuit using a lumped constant element, a circuit using a distributed constant line, a circuit combining a lumped constant and a distributed constant, an L-C type matching circuit, a λ/4 line, or the like is used.

The fourth amplifier 4 is an amplifier that amplifies an input signal output from the fourth input matching circuit 25. An input terminal of the fourth amplifier 4 is connected to the fourth input matching circuit 25, and an output terminal of the fourth amplifier 4 is connected to the fourth output circuit 8. For example, an FET, an HBT, an HEMT, or the like is used for a transistor of the fourth amplifier 4. More specifically, the fourth amplifier 4 corresponds to the amplifier 40 illustrated in FIG. 3 and includes, as an example, the input capacitance 41, the current source 42, and the output capacitance 43, but is not limited to these configurations.

The fourth output circuit 8 is a circuit that modulates an output load of the fourth amplifier 4 to the current source 42. An input of the fourth output circuit 8 is connected to the output terminal of the fourth amplifier 4, and an output of the fourth output circuit 8 is connected to the combining point 10 of the second small branch combining circuit. More specifically, the fourth output circuit 8 corresponds to the output circuit 44 illustrated in FIG. 3 and includes the output capacitance 43 of the fourth amplifier 4, the output line 45, the capacitance 46, and the output line 47, but is not limited to these configurations.

The first small branch combining circuit 19 is a circuit that combines and outputs an output of the first amplifier 1 via the first output circuit 5 and an output of the second amplifier 2 via the second output circuit 6. For the sake of description, a point at which power of the first output circuit 5 and power of the second output circuit 6 are combined is referred to as the combining point 9 of the first small branch combining circuit.

The second small branch combining circuit 20 is a circuit that combines and outputs an output of the third amplifier 3 via the third output circuit 7 and an output of the fourth amplifier 4 via the fourth output circuit 8. For the sake of description, a point at which power of the third output circuit 7 and power of the fourth output circuit 8 are combined is referred to as the combining point 10 of the second small branch combining circuit.

The large branch combining circuit 21 includes the fifth output circuit 11 that modulates an output load of the first small branch combining circuit to the combining point 9 and the sixth output circuit 12 that modulates an output load of the second small branch combining circuit to the combining point 10, and is a circuit that combines and outputs an output of the combining point 9 of the first small branch combining circuit via the fifth output circuit 11 and an output of the combining point 10 of the second small branch combining circuit via the sixth output circuit 12. For description, a point at which power of the fifth output circuit 11 and power of the sixth output circuit 12 are combined is referred to as the combining point 13 of the large branch combining circuit.

The output matching circuit 26 is a circuit that matches impedance at the combining point 13 of the large branch combining circuit with a load of the output terminal 18. For the output matching circuit 26, for example, a circuit using a lumped constant element, a circuit using a distributed constant line, a circuit combining a lumped constant and a distributed constant, an L-C type matching circuit, a λ/4 line, or the like is used.

The first output circuit 5 and the second output circuit 6 include circuits having mutually different electrical lengths. At a center frequency, the electrical length of the first output circuit 5 is 90 degrees, and the electrical length of the second output circuit 6 is 180 degrees.

In addition, equivalent impedance of the first output circuit 5 and the second output circuit 6 matches output resistance (load) at a saturation output of the first amplifier 1. In this case, the output line 35 and the output line 45 have electrical lengths shorter than 90 degrees and characteristic impedance higher than the output resistance of the amplifier. The output line 47 has an electrical length of 90 degrees and characteristic impedance matching the output resistance. The capacitance 36 matches the output capacitance 33 of the first amplifier 1, and the capacitance 46 matches the output capacitance 43 of the second amplifier 2.

The third output circuit 7 and the fourth output circuit 8 include circuits having mutually different electrical lengths. At a center frequency, the electrical length of the third output circuit 7 is 90 degrees, and the electrical length of the fourth output circuit 8 is 180 degrees.

In addition, equivalent impedance of the third output circuit 7 and the fourth output circuit 8 matches output resistance (load) at a saturation output of the third amplifier 3. In this case, the output line 35 and the output line 45 have electrical lengths shorter than 90 degrees and characteristic impedance higher than the output resistance of the amplifier. The output line 47 has an electrical length of 90 degrees and characteristic impedance matching the output resistance. The capacitance 36 matches the output capacitance 33 of the first amplifier 1, and the capacitance 46 matches the output capacitance 43 of the second amplifier 2.

The fifth output circuit 11 and the sixth output circuit 12 include circuits having mutually different electrical lengths. At a center frequency, the electrical length of the fifth output circuit 11 is 90 degrees, and the electrical length of the sixth output circuit 12 is an integral multiple of 180 degrees.

In addition, equivalent impedance of the fifth output circuit 11 and the sixth output circuit 12 matches half the output resistance (load) at the time of saturation output of the first amplifier 1.

The output of the first amplifier 1, the output of the second amplifier 2, the output of the third amplifier 3, and the output of the fourth amplifier 4 are not isolated in any path via the first small branch combining circuit 19, the second small branch combining circuit 20, and the large branch combining circuit 21.

The Doherty amplifier 1000A may include a bias setting circuit 95A as illustrated in FIG. 1.

In a case where the bias setting circuit 95A illustrated in FIG. 1 is provided, the bias setting circuit 95A is a so-called power supply device. In a case of the Doherty amplifier 1000A including four amplifiers, specifically, the power supply device is, for example, a 4ch DC stable power supply or a DC-DC converter. A power supply 90A as the power supply device may be a 4ch power supply or four independent power supplies. A configuration of the power supply device may be any configuration that can control to change at least a bias voltage of each amplifier, and includes a configuration within a range in which this can be implemented.

In the bias setting circuit 95A according to the first embodiment, for example, the bias of each amplifier is set in advance on the basis of a signal from the outside. That is, biases for the first amplifier, the second amplifier, the third amplifier, and the fourth amplifier are set in advance by the bias setting circuit 95A illustrated in FIG. 1.

More specifically, in the first embodiment, gate biases of the first amplifier 1, the second amplifier 2, the third amplifier 3, and the fourth amplifier 4 are biased to the vicinity of a threshold (threshold voltage Vₜₕ) by the bias setting circuit 95A. That is, the bias of each of the amplifiers is fixed to the threshold voltage Vₜₕ of the amplifier. In this case, on/off of the amplifier is switched depending on presence or absence of an input signal.

Electrical characteristics (output resistance and amplitude) of the first amplifier 1, the second amplifier 2, the third amplifier 3, and the fourth amplifier 4 are the same.

First, a connection configuration will be described.

An output of the first signal source 14 is connected to the first input matching circuit 22. An output of the first input matching circuit 22 is connected to an input of the first amplifier 1. The output of the first amplifier 1 is connected to the input of the first output circuit 5. The output of the first output circuit 5 is connected to the combining point 9 of the first small branch combining circuit.

An output of the second signal source 15 is connected to the second input matching circuit 23. An output of the second input matching circuit 23 is connected to an input of the second amplifier 2. The output of the second amplifier 2 is connected to the input of the second output circuit 6. The output of the second output circuit 6 is connected to the combining point 9 of the first small branch combining circuit.

The combining point 9 of the first small branch combining circuit is connected to an input of the fifth output circuit 11. An output of the fifth output circuit 11 is connected to the combining point 13 of the large branch combining circuit.

An output of the third signal source 16 is connected to the third input matching circuit 24. An output of the third input matching circuit 24 is connected to an input of the third amplifier 3. The output of the third amplifier 3 is connected to the input of the third output circuit 7. The output of the third output circuit 7 is connected to the combining point 10 of the second small branch combining circuit.

An output of the fourth signal source 17 is connected to the fourth input matching circuit 25. An output of the fourth input matching circuit 25 is connected to an input of the fourth amplifier 4. The output of the fourth amplifier 4 is connected to the input of the fourth output circuit 8. The output of the fourth output circuit 8 is connected to the combining point 10 of the second small branch combining circuit.

The combining point 10 of the second small branch combining circuit is connected to an input of the sixth output circuit 12. An output of the sixth output circuit 12 is connected to the combining point 13 of the large branch combining circuit.

The combining point 13 of the large branch combining circuit is connected to the output matching circuit 26. An output of the output matching circuit 26 is connected to the output terminal 18.

Here, a concept of a configuration of the Doherty amplifier 1000 including four or more amplifiers will be described.

The Doherty amplifier 1000 illustrated in FIG. 4 includes an amplifier 200A, an amplifier 200B, a large branch combining circuit 221, an output matching circuit 226, and the output terminal 18.

Each of the amplifier 200A or the amplifier 200B has a configuration regarded as an amplifier and including, for example, the first amplifier 1, the second amplifier 2, the third amplifier 3, the fourth amplifier 4, the first output circuit 5, the second output circuit 6, the third output circuit 7, the fourth output circuit 8, the combining point 9 of the first small branch combining circuit, the combining point 10 of the second small branch combining circuit, the fifth output circuit 11, the sixth output circuit 12, the combining point 13 of the large branch combining circuit, the first signal source 14, the second signal source 15, the third signal source 16, the fourth signal source 17, the output terminal 18, the first small branch combining circuit 19, the second small branch combining circuit 20, the large branch combining circuit 21, the first input matching circuit 22, the second input matching circuit 23, the third input matching circuit 24, and the fourth input matching circuit 25. Note that the amplifier 200A or the amplifier 200B may have a configuration in which the number of amplifiers included therein is different from each other.

The large branch combining circuit 221 illustrated in FIG. 4 is a circuit that implements a function similar to that of the large branch combining circuit 21 described above, and is a circuit that is connected to an output of the amplifier 200A and an output of the amplifier 200B and synthesizes and outputs the output of the amplifier 200A and the output of the amplifier 200B.

The output matching circuit 226 illustrated in FIG. 4 is a circuit that implements a function similar to that of the output matching circuit 26 described above, and is connected to a combining point of the large branch combining circuit 221. An output of the output matching circuit 226 is connected to the output terminal 18.

According to such an idea, the Doherty amplifier according to the present disclosure can be implemented by including a combining circuit of a tournament type that stepwisely combines outputs of amplifiers, the combining circuit having an asymmetric configuration as viewed from each combining point.

Note that, in the description of FIG. 4, description of a configuration corresponding to the bias setting circuit (alternatively, a bias control circuit to be described later) is omitted.

Next, an operation of the Doherty amplifier 1000A illustrated in FIG. 1 will be described.

With respect to output power, the amplification operation of the present amplifier is divided into a high power region from a saturation output to the vicinity of 6 dB backoff, a medium power region from the vicinity of 6 dB backoff to the vicinity of 12 dB backoff, and a low power region equal to or less than the vicinity of 12 dB backoff. Furthermore, depending on a frequency, any one of the four amplifiers operates in the low power region, any one of the three remaining amplifiers in addition to the amplifier operating in the low power region operate in the medium power region, and all the amplifiers operate in the high power region. By changing a relationship among the amplifiers operating in each power region depending on the frequency, operation over a wide frequency is implemented.

First, a Doherty operation mode at a center frequency f0 will be described.

In the Doherty operation mode at the center frequency f0, only the third amplifier 3 operates up to about 1/4 of the saturation output of each amplifier in the low power region, the first amplifier 1 and the third amplifier 3 operate up to about 1/2 of the saturation output of each amplifier in the medium power region, and the first amplifier 1, the second amplifier 2, the third amplifier 3, and the fourth amplifier 4 operate up to the saturation output of each amplifier in the high power region. In the Doherty operation mode at the center frequency f0, the third amplifier 3 operates as a carrier amplifier, the first amplifier 1 operates as a first peaking amplifier, and the second amplifier 2 and the fourth amplifier 4 operate as second peaking amplifiers.

It is assumed that each signal source has an output that excites each amplifier from off to a saturation output. In this case, the operation is achieved in that the third signal source 16 operates from off to about 1/4 output in the low power region, the third signal source 16 operates from about 1/4 to about 1/2 output and the first signal source 14 additionally operates from off to about 1/2 output in the medium power region, and the third signal source 16 and the first signal source 14 operate from 1/2 to maximum output and the second signal source 15 and the fourth signal source 17 additionally operate from off to maximum output in the high power region.

A load modulation operation in the Doherty operation mode at the center frequency f0 will be schematically described. Note that output resistance at the time of saturation output of each amplifier is Ropt, and impedance when the output terminal 18 is viewed from the combining point 13 of the large branch combining circuit is 0.25 × Ropt.

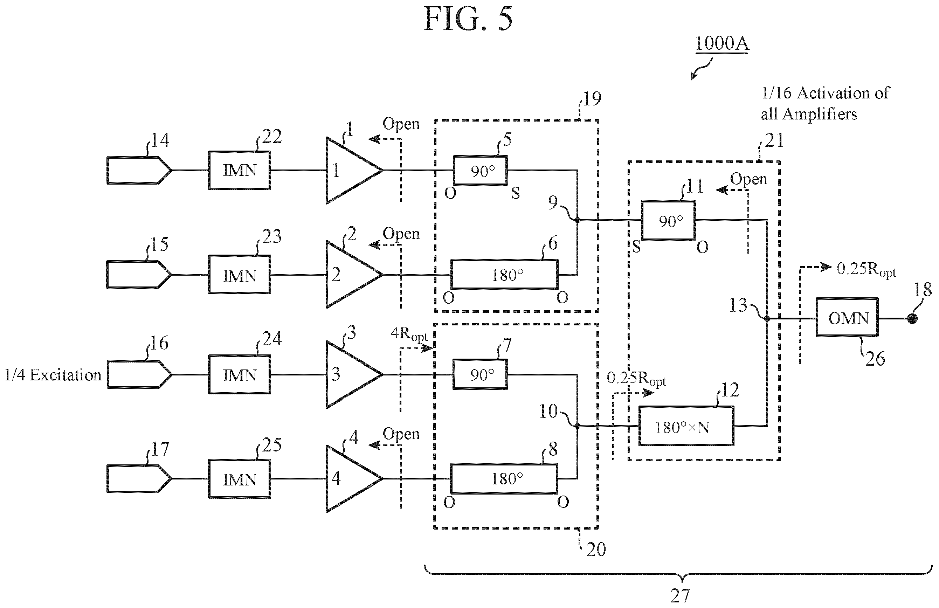

FIG. 5 is a diagram illustrating transformation of a load in a low power region of the amplifier according to the first embodiment of the present disclosure. Note that, in FIG. 5, the bias setting circuit 95A is omitted.

First, the load modulation operation in the low power region illustrated in FIG. 5 is as follows. As described above, in each signal source immediately before entering the medium power region from the low power region, the third signal source 16 outputs, to the third amplifier 3, the input signal having amplitude that drives the third amplifier 3 with the output power of 1/4 of the maximum output, and the first amplifier 1, the second amplifier 2, and the fourth amplifier 4 have no input signal. Therefore, the first amplifier 1, the second amplifier 2, and the fourth amplifier 4 are stopped because there is no input signal, and outputs of the first amplifier 1, the second amplifier 2, and the fourth amplifier 4 are in an open state ("Open" in FIG. 5. The same applies hereafter.). In this case, a load of the third amplifier 3 is determined as follows. First, since the electrical length of the first output circuit 5 is 90 degrees, opening of the output of the first amplifier 1 is subjected to impedance conversion, and impedance when the first amplifier 1 side is viewed from the combining point 9 of the first small branch combining circuit is a short circuit. On the other hand, since the electrical length of the second output circuit 6 is 180 degrees, impedance when the second amplifier 2 side is viewed from the combining point 9 of the first small branch combining circuit is open as the output of the second amplifier 2. Therefore, impedance when the amplifier side is viewed from the combining point 9 of the first small branch combining circuit is a short circuit. Next, since the electrical length of the fifth output circuit 11 is 90 degrees, a short circuit at the combining point 9 of the first small branch combining circuit is subjected to impedance conversion, and impedance when the amplifiers are viewed from the combining point 13 of the large branch combining circuit is open. Next, since output impedance of the fifth output circuit 11 is open, impedance of the combining point 13 of the large branch combining circuit is 0.25 × Ropt, and the electrical length of the sixth output circuit 12 is an integral multiple of 180 degrees, impedance when an output side is viewed from the combining point 10 of the second small branch combining circuit is 0.25 × Ropt. Furthermore, impedance when the fourth amplifier 4 is seen from the combining point 10 of the second small branch combining circuit is open. As a result, since impedance on the output side of the third output circuit 7 is 0.25 × Ropt and characteristic impedance of the third output circuit 7 is Ropt, a load viewed from the third amplifier 3 is 4 × Ropt due to an effect of modulation of the impedance of the third output circuit 7. Thus, the third amplifier 3 is in a state in which a high resistive load is connected to the output in the low power region, and a highly efficient operation is performed.

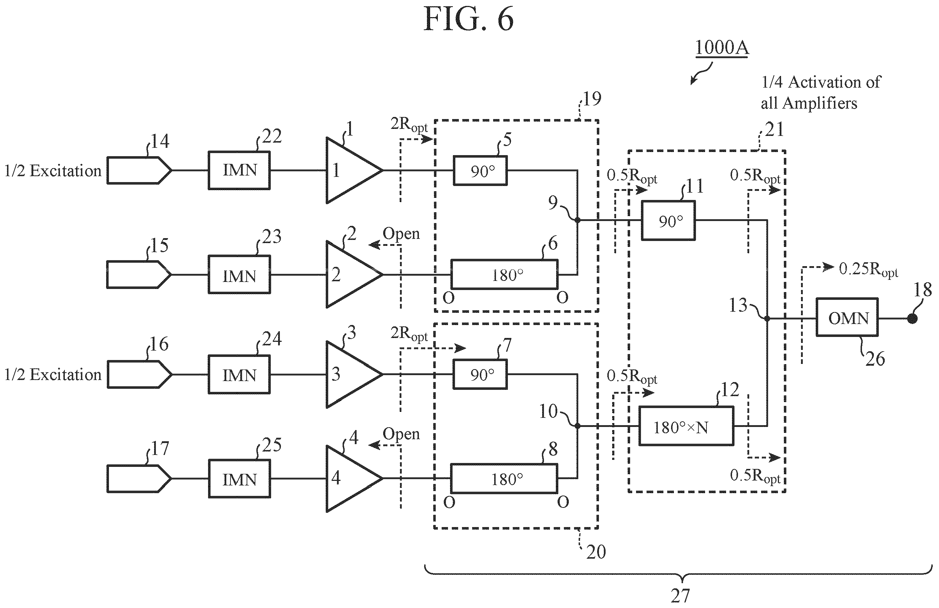

FIG. 6 is a diagram illustrating transformation of a load in a medium power region of the amplifier according to the first embodiment of the present disclosure. Note that, in FIG. 6, the bias setting circuit 95A is omitted.

Next, the load modulation operation in the medium power region illustrated in FIG. 6 is as follows. In each signal source immediately before entering the high power region from the medium power region, as described above, the first signal source 14 outputs the input signal having amplitude that drives the first amplifier 1 with the output power of 1/2 of the maximum output to the first amplifier 1, the third signal source 16 outputs the input signal having amplitude that drives the third amplifier 3 with the output power of 1/2 of the maximum output to the third amplifier 3, and the second amplifier 2 and the fourth amplifier 4 have no input signal. Therefore, the second amplifier 2 and the fourth amplifier 4 are stopped because there is no input signal, and outputs of the second amplifier 2 and the fourth amplifier 4 are in an open state ("Open" in FIG. 6. The same applies hereafter.). In this case, loads of the first amplifier 1 and the third amplifier 3 are determined as follows. First, the first amplifier 1 is operated at the output power of 1/2 of the maximum output on the first small branch combining circuit 19 side, and the third amplifier 3 is operated at the output power of 1/2 of the maximum output on the second small branch combining circuit 20 side. If magnitudes of the output power of the first amplifier 1 and the third amplifier 3 are the same, output power at the combining point 9 of the first small branch combining circuit and that at the combining point 10 of the second small branch combining circuit are equal. In this case, since a load distributed from the combining point 13 of the large branch combining circuit to the first small branch combining circuit 19 side is equal, impedance when the output side is viewed from the fifth output circuit 11 and impedance when the output side is viewed from the sixth output circuit 12 are 0.5 × Ropt. Since characteristic impedances of the fifth output circuit 11 and the sixth output circuit 12 are 0.5 × Ropt, impedance conversion from the output to the input does not occur, and impedance when the output side is viewed from the combining point 9 of the first small branch combining circuit and the combining point 10 of the second small branch combining circuit is 0.5 × Ropt. Further, impedance when the second amplifier 2 is seen from the combining point 9 of the first small branch combining circuit is open, and impedance when the fourth amplifier 4 is seen from the combining point 10 of the second small branch combining circuit is open. As a result, since impedance on the output side of the first output circuit 5 is 0.5 × Ropt and characteristic impedance of the first output circuit 5 is Ropt, a load viewed from the first amplifier 1 is 2 × Ropt due to an effect of modulation of the impedance of the first output circuit 5, and the first amplifier 1 is in a state in which a medium resistive load is connected to the output in the medium power region. In addition, since impedance on the output side of the third output circuit 7 is 0.5 × Ropt and characteristic impedance of the third output circuit 7 is Ropt, a load viewed from the third amplifier 3 is 2 × Ropt due to an effect of modulation of the impedance of the third output circuit 7. As a result, the third amplifier 3 is in a state in which a medium resistive load is connected to the output in the medium power region, and a highly efficient operation is performed.

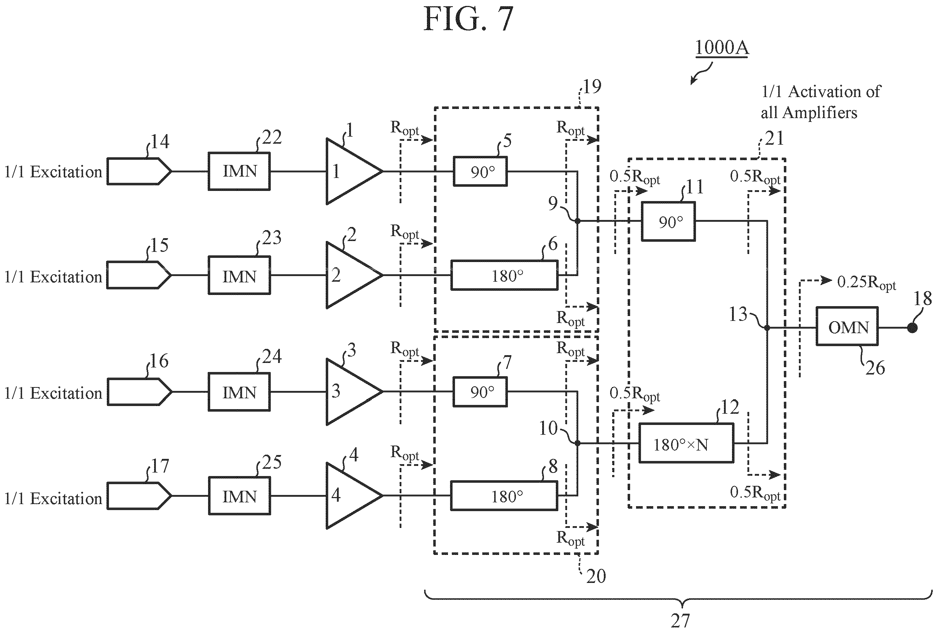

FIG. 7 is a diagram illustrating transformation of a load in a high power region of the amplifier according to the first embodiment of the present disclosure. Note that, in FIG. 7, the bias setting circuit 95A is omitted.

Finally, the load modulation operation in the high power region illustrated in FIG. 7 is as follows. As described above, in all the signal sources, each signal source at the time of the saturation output in the large power region outputs the input signal having amplitude that drives each amplifier with the saturation output power that is the maximum output. In this case, loads of the first amplifier 1, the second amplifier 2, the third amplifier 3, and the fourth amplifier 4 are determined as follows. First, the first amplifier 1 and the second amplifier 2 operate with the saturation output power on the first small branch combining circuit 19 side, and the third amplifier 3 and the fourth amplifier 4 operate with the saturation output power on the second small branch combining circuit 20 side. If magnitudes of outputs of the respective amplifiers are the same, output power at the combining point 9 of the first small branch combining circuit and that at the combining point 10 of the second small branch combining circuit are equal. In this case, since loads distributed from the combining point 13 of the large branch combining circuit to the first small branch combining circuit 19 side and the second small branch combining circuit 20 side are equal, impedance when the output side is viewed from the fifth output circuit 11 and impedance when the output side is viewed from the sixth output circuit 12 are 0.5 × Ropt. Since characteristic impedances of the fifth output circuit 11 and the sixth output circuit 12 are 0.5 × Ropt, impedance conversion from the output to the input does not occur, and impedance when the output side is viewed from the combining point 9 of the first small branch combining circuit and the combining point 10 of the second small branch combining circuit is 0.5 × Ropt. Next, since the first amplifier 1 and the second amplifier 2 operate with the saturation output power on the first small branch combining circuit 19 side, if the magnitudes of the outputs of the respective amplifiers are the same, the output power at the output of the first output circuit 5 and that at the output of the second output circuit 6 are equal. In this case, since loads distributed from the combining point 9 of the first small branch combining circuit to the first output circuit 5 side and the second output circuit 6 side are equal, impedance when the output side is viewed from the first output circuit 5 and impedance when the output side is viewed from the second output circuit 6 are Ropt. Since characteristic impedances of the first output circuit 5 and the second output circuit 6 are Ropt, impedance conversion from the output to the input does not occur, and impedance when the output side is viewed from the first amplifier 1 and the second amplifier 2 is Ropt. Furthermore, since the third amplifier 3 and the fourth amplifier 4 operate with the saturation output power on the second small branch combining circuit 20 side, if the magnitudes of the outputs of the respective amplifiers are the same, the output power at the output of the third output circuit 7 and that at the output of the fourth output circuit 8 are equal. In this case, since loads distributed from the combining point 10 of the second small branch combining circuit to the third output circuit 7 side and the fourth output circuit 8 side are equal, impedance when the output side is viewed from the third output circuit 7 and impedance when the output side is viewed from the fourth output circuit 8 are Ropt. Since characteristic impedances of the third output circuit 7 and the fourth output circuit 8 are Ropt, impedance conversion from the output to the input does not occur, and the impedance when the output side is viewed from the third amplifier 3 and the fourth amplifier 4 is Ropt. As a result, the first amplifier 1, the second amplifier 2, the third amplifier 3, and the fourth amplifier 4 are connected to a resistive load corresponding to the saturation output in the large power region, and the saturation output is obtained.

Note that, in any operation region, at each of the combining point 9 of the first small branch combining circuit, the combining point 10 of the second small branch combining circuit, and the combining point 13 of the large branch combining circuit, a phase of each signal source is controlled in such a manner that a phase of the signal from each path is in-phase synthetic.

Note that, at the center frequency f0, when all the amplifiers continuously increases the power from a minimum power state to the saturation output, the output power of the third amplifier 3 continuously increases from the minimum power state to the saturation output, the first amplifier 1 is activated immediately after entering the medium power region from the low power region and the output power thereof continuously increases from the saturation output, and the second amplifier 2 and the fourth amplifier 4 are activated immediately after entering the high power region from the medium power region and the output power thereof continuously increases from the saturation output.

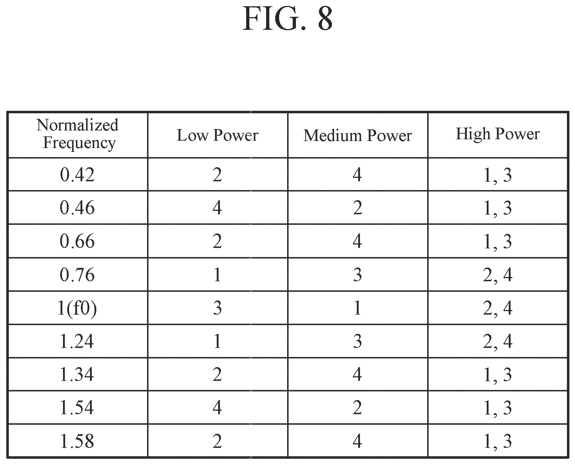

FIG. 8 is a table illustrating a relationship between a frequency and amplifiers that perform an amplification operation in an operation power region in the Doherty amplifier 1000A according to the present disclosure.

Furthermore, the Doherty amplifier 1000A changes the amplifier to be activated in each power region for each frequency even at the frequency illustrated in FIG. 8 according to a result investigated by simulation, whereby load modulation for increasing a load of the amplifier in each power region is established and high-efficiency operation is established by a concept similar to that of the center frequency f0. Note that the electrical length of each circuit changes depending on the frequency, for example, in proportion to the frequency in a case of an ideal transmission line.

For example, in a Doherty operation mode at 0.46 × f0 lower than the center frequency, only the fourth amplifier 4 operates up to about 1/4 of the saturation output of each amplifier in the low power region, the second amplifier 2 and the fourth amplifier 4 operate up to about 1/2 of the saturation output of each amplifier in the medium power region, and the first amplifier 1, the second amplifier 2, the third amplifier 3, and the fourth amplifier 4 operate up to the saturation output of each amplifier in the high power region. In the Doherty operation mode at the frequency of 0.46 × f0, the fourth amplifier 4 operates as a carrier amplifier, the second amplifier 2 operates as a first peaking amplifier, and the first amplifier 1 and the third amplifier 3 operate as second peaking amplifiers.

In the Doherty amplifier 1000A, activation order of the amplifiers that perform the amplification operation according to the relationship between the frequency and the operation power region as illustrated in FIG. 8 is specifically as follows.

In the Doherty amplifier 1000A, at the center frequency f0, the third amplifier operates when the input signal has low power, the first amplifier joins the operation when the input signal has medium power, and the second amplifier and the fourth amplifier join the operation when the input signal has high power.

In the Doherty amplifier 1000A, in a first frequency group (a normalized frequency of 0.76 and a normalized frequency of 1.24 when the center frequency f0 is 1), the first amplifier operates when the input signal has low power, the third amplifier joins the operation when the input signal has medium power, and the second amplifier and the fourth amplifier join the operation when the input signal has high power.

In the Doherty amplifier 1000A, in a second frequency group (a normalized frequency of 0.42, a normalized frequency of 0.66, a normalized frequency of 1.34, and a normalized frequency of 1.58 when the center frequency f0 is 1), the second amplifier operates when the input signal has low power, the fourth amplifier joins the operation when the input signal has medium power, and the first amplifier and the third amplifier join the operation when the input signal has high power.

In the Doherty amplifier 1000A, in a third frequency group (a normalized frequency of 0.46 and a normalized frequency of 1.54 when the center frequency f0 is 1), the fourth amplifier operates when the input signal has low power, the second amplifier joins the operation when the input signal has medium power, and the first amplifier and the third amplifier join the operation when the input signal has high power.

As described above, the combining circuit of tournament type 27 which is asymmetric as viewed from each branch is provided, and the load modulation is changed, and the operation mode of the amplifier is switched by changing the activation order of the four amplifiers depending on the output power with respect to the frequency. Therefore, the load of each amplifier is modulated and increased from the time of backoff corresponding to the average power of the signal having the PAPR of equal to or more than 6 dB to the saturation output, whereby a highly efficient operation is implemented even at the time of backoff.

The Doherty amplifier according to the first embodiment of the present disclosure will be described below in an organized manner.

(1a) In a Doherty amplifier according to the present disclosure, the number of amplifiers contributing to an amplification operation changes depending on power of an input signal, the Doherty amplifier including at least four or more amplifiers, in which order in which the amplifiers contribute to the amplification operation differs depending on a frequency of the input signal.

As a result, the present disclosure has an effect of providing a Doherty amplifier that operates with high efficiency in a wide band even at the time of backoff exceeding 6 dB.

(1b) The Doherty amplifier according to the present disclosure, further includes a combining circuit that is a combining circuit of tournament type to stepwisely combine outputs of the amplifiers two by two, the combining circuit having an asymmetric configuration as viewed from each of combining points.

As a result, in the present disclosure, it is possible to further provide a Doherty amplifier that operates with high efficiency in a wide band even at the time of backoff exceeding 6 dB by a suitable configuration.

(1c) In the Doherty amplifier according to the present disclosure, the amplifiers are constituted by a first amplifier, a second amplifier, a third amplifier, and a fourth amplifier, one amplifier of the amplifiers operates when the input signal has low power, two amplifiers of the amplifiers operate when the input signal has medium power, and four amplifiers of the amplifiers operate when the input signal has high power.

As a result, in the present disclosure, it is possible to further provide a Doherty amplifier that operates with high efficiency in a wide band even at the time of backoff exceeding 6 dB by a suitable configuration using the four amplifiers.

(1d) In the Doherty amplifier according to the present disclosure, the amplification operation is performed in such a manner that:
at a center frequency, the third amplifier operates when the input signal has low power, the first amplifier joins the operation when the input signal has medium power, and the second amplifier and the fourth amplifier join the operation when the input signal has high power,
in a first frequency group, the first amplifier operates when the input signal has low power, the third amplifier joins the operation when the input signal has medium power, and the second amplifier and the fourth amplifier join the operation when the input signal has high power,
in a second frequency group, the second amplifier operates when the input signal has low power, the fourth amplifier joins the operation when the input signal has medium power, and the first amplifier and the third amplifier join the operation when the input signal has high power, and
in a third frequency group, the fourth amplifier operates when the input signal has low power, the second amplifier joins the operation when the input signal has medium power, and the first amplifier and the third amplifier join the operation when the input signal has high power.

As a result, in the present disclosure, it is possible to further provide a Doherty amplifier that operates with high efficiency in a wide band even at the time of backoff exceeding 6 dB by a more suitable configuration using the four amplifiers.

(1e) The Doherty amplifier according to the present disclosure, further includes signal sources connected to the amplifiers, in which a bias of each of the amplifiers is fixed to a threshold voltage of the amplifier.

As a result, in the present disclosure, it is possible to further provide a Doherty amplifier in which activation order of the amplifiers is controlled by the input signal.

### Second Embodiment.

In the operation mode of the first embodiment, the biases of the four amplifiers are fixed near the threshold, and the activation order of the four amplifiers depending on the output power is changed with respect to the frequency by controlling the four signal sources. On the other hand, it is also possible to change the activation order of the four amplifiers depending on the output power with respect to the frequency by distributing signals from one signal source and changing the biases of the four amplifiers.

A configuration example of a Doherty amplifier according to a second embodiment of the present disclosure will be described.

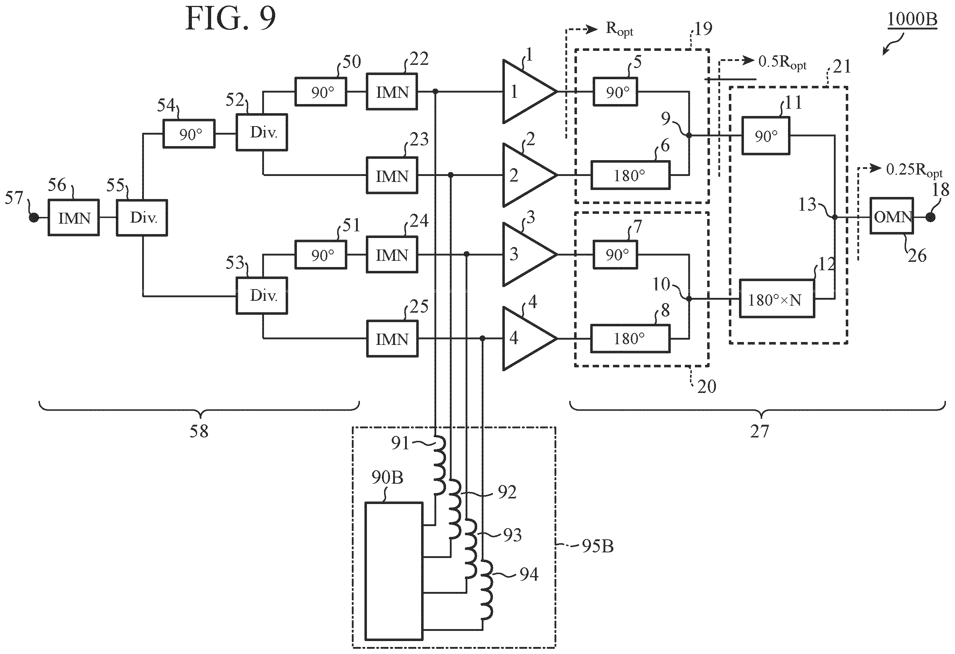

FIG. 9 is a diagram illustrating a configuration of a Doherty amplifier 1000B according to the second embodiment of the present disclosure.

In description of the second embodiment, description of the configuration described in the first embodiment will be appropriately omitted, and differences from the first embodiment will be mainly described.

The Doherty amplifier 1000B includes one signal source and a distribution circuit 58.

Specifically, differences between the Doherty amplifier 1000B and the Doherty amplifier 1000A of the first embodiment are to have one signal source for each amplifier instead of four signal sources, and to include a first small branch phase adjustment line 50, a first small branch distribution circuit (hereinafter also referred to as a "first small branched distribution circuit") 52, a second small branch phase adjustment line 51, a second small branch distribution circuit (hereinafter also referred to as a "second small branched distribution circuit") 53, a large branch phase adjustment line 54, a large branch distribution circuit (hereinafter also referred to as a "large branched distribution circuit") 55, a fifth input matching circuit 56, and an input terminal 57.

The first small branch phase adjustment line 50, the first small branch distribution circuit 52, the second small branch phase adjustment line 51, the second small branch distribution circuit 53, the large branch phase adjustment line 54, the large branch distribution circuit 55, the fifth input matching circuit 56, and the input terminal 57 constitute the distribution circuit 58 in the Doherty amplifier 1000B.

The fifth input matching circuit 56 is a circuit that matches impedance of the input terminal 57 with input impedance of the large branch distribution circuit 55. For the fifth input matching circuit 56, for example, a circuit using a lumped constant element, a circuit using a distributed constant line, a circuit combining a lumped constant and a distributed constant, an L-C type matching circuit, a λ/4 line, or the like is used.

The large branch distribution circuit 55 is a circuit that distributes a signal input from the input terminal 57 via the fifth input matching circuit 56 to the first small branch and the second small branch. The large branch distribution circuit 55 is connected to an output of the fifth input matching circuit 56, an input of the large branch phase adjustment line 54, and an input of the second small branch distribution circuit 53. The large branch distribution circuit 55 is, for example, a Wilkinson distributor, a hybrid circuit, or the like, and as a component thereof, a circuit using a lumped constant element, a circuit using a distributed constant line, a circuit combining a lumped constant and a distributed constant, an L-C type matching circuit, a λ/4 line, or the like is used.

The large branch phase adjustment line 54 is a circuit that makes an electrical length from the input of the large branch phase adjustment line 54 to the output of the fifth output circuit 11 equal to an electrical length from the input of the second small branch distribution circuit 53 to the output of the sixth output circuit 12. For the large branch phase adjustment line 54, for example, a circuit using a lumped constant element, a circuit using a distributed constant line, a circuit combining a lumped constant and a distributed constant, an L-C type matching circuit, a λ/4 line, or the like is used.

The first small branch distribution circuit 52 is a circuit that distributes a signal input from the large branch distribution circuit 55 via the large branch phase adjustment line 54 to the first amplifier 1 and the second amplifier 2. The first small branch distribution circuit 52 is connected to an output of the large branch phase adjustment line 54 and inputs of the first small branch phase adjustment line 50 and the second input matching circuit 23. The first small branch distribution circuit 52 is, for example, a Wilkinson distributor, a hybrid circuit, or the like, and as a component thereof, a circuit using a lumped constant element, a circuit using a distributed constant line, a circuit combining a lumped constant and a distributed constant, an L-C type matching circuit, a λ/4 line, or the like is used.

The first small branch phase adjustment line 50 is a circuit that makes an electrical length from the input of the first small branch phase adjustment line 50 to the output of the first output circuit 5 equal to an electrical length from the input of the second input matching circuit 23 to the output of the second output circuit 6. For the first small branch phase adjustment line 50, for example, a circuit using a lumped constant element, a circuit using a distributed constant line, a circuit combining a lumped constant and a distributed constant, an L-C type matching circuit, a λ/4 line, or the like is used.

The second small branch distribution circuit 53 is a circuit that distributes a signal input from the large branch distribution circuit 55 to the third amplifier 3 and the fourth amplifier 4. The second small branch distribution circuit 53 is connected to an output of the large branch distribution circuit 55 and inputs of the second small branch phase adjustment line 51 and the fourth input matching circuit 25. The second small branch distribution circuit 53 is, for example, a Wilkinson distributor, a hybrid circuit, or the like, and as a component thereof, a circuit using a lumped constant element, a circuit using a distributed constant line, a circuit combining a lumped constant and a distributed constant, an L-C type matching circuit, a λ/4 line, or the like is used.

The second small branch phase adjustment line 51 is a circuit that makes an electrical length from the input of the second small branch phase adjustment line 51 to the output of the third output circuit 7 equal to an electrical length from the input of the fourth input matching circuit 25 to the output of the fourth output circuit 8. For the second small branch phase adjustment line 51, for example, a circuit using a lumped constant element, a circuit using a distributed constant line, a circuit combining a lumped constant and a distributed constant, an L-C type matching circuit, a λ/4 line, or the like is used.

The Doherty amplifier 1000B may include a bias setting circuit 95B illustrated in FIG. 9.

In a case where the bias setting circuit 95B illustrated in FIG. 9 is provided, the bias setting circuit 95B is a so-called power supply device. In a case of the Doherty amplifier 1000B including four amplifiers, specifically, the power supply device is, for example, a 4ch DC stable power supply or a DC-DC converter. A power supply 90B as the power supply device may be a 4ch power supply or four independent power supplies. A configuration of the power supply device may be any configuration that can control to change at least a bias voltage of each amplifier, and includes a configuration within a range in which this can be implemented.

The bias setting circuit 95B in the second embodiment sets the bias of each amplifier in advance on the basis of, for example, a signal from the outside. That is, biases for the first amplifier, the second amplifier, the third amplifier, and the fourth amplifier are set in advance by the bias setting circuit 95B illustrated in FIG. 9.

Specifically, by the bias setting circuit 95B, each of a gate bias of the first amplifier 1, a gate bias of the second amplifier 2, a gate bias of the third amplifier 3, and a gate bias of the fourth amplifier 4 is set to a bias class such as an amplifier (class AB) to be biased shallower than the vicinity of the threshold (threshold voltage Vₜₕ) (voltage V_{AB}), an amplifier (class C) to be biased deeper than the vicinity of the threshold (threshold voltage Vₜₕ) (voltage Vc), and an amplifier (class deep C) to be biased deeper than the vicinity of the threshold (threshold voltage Vₜₕ) (voltage V_{deepC}) depending on the frequency. That is, the bias setting circuit 95B sets the bias class on the basis of a relationship between the frequency and the bias voltage V_{AB} of class AB > the threshold voltage Vₜₕ of the center frequency > the bias voltage Vc of class C > the bias voltage V_{deepC} of deep class C.

First, a connection configuration will be described.

An output of the input terminal 57 is connected to an input of the fifth input matching circuit 56. The output of the fifth input matching circuit 56 is connected to an input of the large branch distribution circuit 55. The output of the large branch distribution circuit 55 is connected to the input of the large branch phase adjustment line 54 and the input of the second small branch distribution circuit 53.

The output of the large branch phase adjustment line 54 is connected to an input of the first small branch distribution circuit 52. An output of the first small branch distribution circuit 52 is connected to the input of the first small branch phase adjustment line 50 and the input of the second input matching circuit 23. An output of the first small branch phase adjustment line 50 is connected to an input of the first input matching circuit 22.

One of the outputs of the large branch distribution circuit 55 is connected to the input of the second small branch distribution circuit 53. An output of the second small branch distribution circuit 53 is connected to the input of the second small branch phase adjustment line 51 and the input of the fourth input matching circuit 25. An output of the second small branch phase adjustment line 51 is connected to an input of the third input matching circuit 24.

Next, an operation of the Doherty amplifier 1000B illustrated in FIG. 9 will be described.

With respect to output power, the amplification operation of the amplifier is divided into a high power region from a saturation output to the vicinity of 6 dB backoff, a medium power region from the vicinity of 6 dB backoff to the vicinity of 12 dB backoff, and a low power region equal to or less than the vicinity of 12 dB backoff. Furthermore, depending on a frequency, any one of the four amplifiers operates in the low power region, any one of the three remaining amplifiers in addition to the amplifier operating in the low power region operate in the medium power region, and all the amplifiers operate in the high power region. By changing a relationship among the amplifiers operating in each power region depending on the frequency, operation over a wide frequency is implemented.

First, a Doherty operation mode at a center frequency f0 will be described.

In the Doherty operation mode at the center frequency f0, only the third amplifier 3 operates up to about 1/4 of the saturation output of each amplifier in the low power region, the first amplifier 1 and the third amplifier 3 operate up to about 1/2 of the saturation output of each amplifier in the medium power region, and the first amplifier 1, the second amplifier 2, the third amplifier 3, and the fourth amplifier 4 operate up to the saturation output of each amplifier in the high power region. In the Doherty operation mode at the center frequency f0, the third amplifier 3 operates as a carrier amplifier, the first amplifier 1 operates as a first peaking amplifier, and the second amplifier 2 and the fourth amplifier 4 operate as second peaking amplifiers.

It is assumed that each signal source has an output that excites each amplifier from off to a saturation output. In this case, since the signals distributed from the input terminal 57 and input to each amplifier have the same amplitude, by appropriately setting the bias, the third amplifier 3 operates from off to about 1/4 output in the low power region, the third amplifier 3 operates from about 1/4 to about 1/2 output and the first amplifier 1 additionally operates from off to about 1/2 output in the medium power region, and the third amplifier 3 and the first amplifier 1 operate from 1/2 to maximum output and the second amplifier 2 and the fourth amplifier 4 additionally operate from off to maximum output in the high power region. In this case, the third amplifier 3 is biased to an amplifier (class AB) to be biased shallower than the vicinity of the threshold, the first amplifier 1 is biased to an amplifier (class C) to be biased deeper than the vicinity of the threshold, and the second amplifier 2 and the fourth amplifier 4 are biased to amplifiers (class deep C) to be biased deeper than the vicinity of the threshold.

A load modulation operation is the same as that in the first embodiment.

Note that, in any operation region, at each of the combining point 9 of the first small branch combining circuit, the combining point 10 of the second small branch combining circuit, and the combining point 13 of the large branch combining circuit, a phase of the signal from each path is adjusted by each phase adjustment line on the input side in such a manner as to be in-phase synthetic.

Note that, at the center frequency f0, when all the amplifiers continuously increases the power from a minimum power state to the saturation output, the output power of the third amplifier 3 continuously increases from the minimum power state to the saturation output, the first amplifier 1 is activated immediately after entering the medium power region from the low power region and the output power thereof continuously increases from the saturation output, and the second amplifier 2 and the fourth amplifier 4 are activated immediately after entering the high power region from the medium power region and the output power thereof continuously increases from the saturation output.

Furthermore, the Doherty amplifier 1000B changes the amplifier to be activated in each power region for each frequency even at the frequency illustrated in FIG. 8, whereby load modulation for increasing a load of the amplifier in each power region is established and high-efficiency operation is established by a concept similar to that of the center frequency f0. Note that the electrical length of each circuit changes depending on the frequency, for example, in proportion to the frequency in a case of an ideal transmission line.

For example, in the Doherty operation mode at 0.46 × f0 lower than the center frequency, only the fourth amplifier 4 operates up to about 1/4 of the saturation output of each amplifier in the low power region, the second amplifier 2 and the fourth amplifier 4 operate up to about 1/2 of the saturation output of each amplifier in the medium power region, and the first amplifier 1, the second amplifier 2, the third amplifier 3, and the fourth amplifier 4 operate up to the saturation output of each amplifier in the high power region. In the Doherty operation mode at the frequency of 0.46 × f0, the fourth amplifier 4 operates as a carrier amplifier, the second amplifier 2 operates as a first peaking amplifier, and the first amplifier 1 and the third amplifier 3 operate as second peaking amplifiers. In this case, the bias class is set in such a manner that the fourth amplifier 4 is an amplifier (class AB) to be biased shallower than the vicinity of the threshold, the second amplifier 2 is an amplifier (class C) to be biased deeper than the vicinity of the threshold, and the first amplifier 1 and the third amplifier 3 are amplifiers (class deep C) to be biased significantly deeper than the vicinity of the threshold.

In the Doherty amplifier 1000B, activation order of the amplifiers that perform the amplification operation according to the relationship between the frequency and the operation power region as illustrated in FIG. 8 is specifically as follows.

In the Doherty amplifier 1000B, at the center frequency f0, the third amplifier operates when the input signal has low power, the first amplifier joins the operation when the input signal has medium power, and the second amplifier and the fourth amplifier join the operation when the input signal has high power.

In the Doherty amplifier 1000B, in a first frequency group (a normalized frequency of 0.76 and a normalized frequency of 1.24 when the center frequency f0 is 1), the first amplifier operates when the input signal has low power, the third amplifier joins the operation when the input signal has medium power, and the second amplifier and the fourth amplifier join the operation when the input signal has high power.

In the Doherty amplifier 1000B, in a second frequency group (a normalized frequency of 0.42, a normalized frequency of 0.66, a normalized frequency of 1.34, and a normalized frequency of 1.58 when the center frequency f0 is 1), the second amplifier operates when the input signal has low power, the fourth amplifier joins the operation when the input signal has medium power, and the first amplifier and the third amplifier join the operation when the input signal has high power.

In the Doherty amplifier 1000B, in a third frequency group (a normalized frequency of 0.46 and a normalized frequency of 1.54 when the center frequency f0 is 1), the fourth amplifier operates when the input signal has low power, the second amplifier joins the operation when the input signal has medium power, and the first amplifier and the third amplifier join the operation when the input signal has high power.

As described above, the combining circuit of tournament type 27 which is asymmetric as viewed from each branch is provided, and the load modulation is changed and the operation mode of the amplifier is switched by changing the activation order of the four amplifiers depending on the output power with respect to the frequency. As a result, the load of each amplifier is modulated and increased from the time of backoff corresponding to the average power of the signal having the PAPR of equal to or more than 6 dB to the saturation output, whereby a highly efficient operation can be implemented even at the time of backoff.

The second embodiment of the present disclosure will be described below in an organized manner.

(2a) The Doherty amplifier according to the present disclosure, includes:
one signal source; and
a distribution circuit to distribute a signal from the signal source to the first amplifier, the second amplifier, the third amplifier, and the fourth amplifier.

As a result, in the present disclosure, it is possible to further provide a Doherty amplifier in which activation order of the amplifiers is controlled by a bias class set for each of the amplifiers.

The Doherty amplifier according to the present disclosure further has configurations similar to those of the above (1a), (1b), (1c), and (1d), and achieves similar effects.

### Third Embodiment.

In the first and second embodiments, the Doherty amplifier in which the output circuit includes the output capacitance of the transistor, the output line, and the capacitance has been described, but the output circuit may include the output capacitance, a wire, and an output line.

In description of a third embodiment, the description of the configuration described in the first embodiment and the configuration described in the second embodiment will be appropriately omitted, and differences from the first embodiment and the second embodiment will be mainly described.

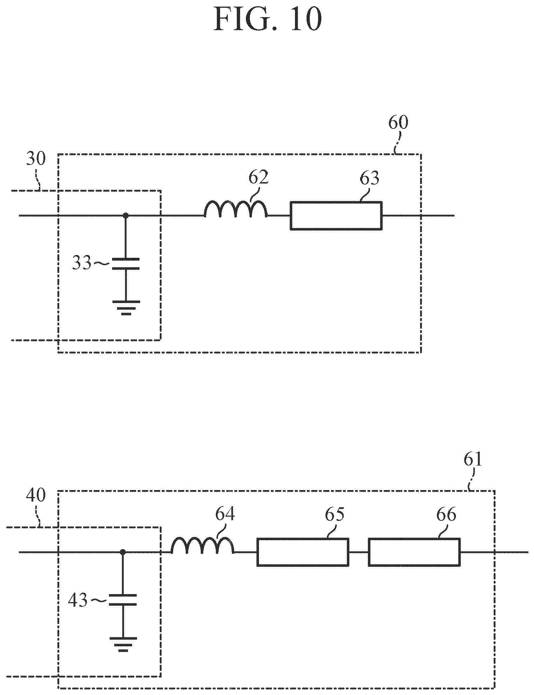

FIG. 10 is a diagram illustrating a configuration of each amplifier of a Doherty amplifier according to the third embodiment of the present disclosure.

A configuration of an output circuit loaded in the Doherty amplifier according to the third embodiment of the present disclosure will be described.

Specifically, the first output circuit 5 and the third output circuit 7 each include the output capacitance 33 of the first amplifier 1 or the third amplifier 3, a wire 62, and an output line 63. The second output circuit 6 and the fourth output circuit 8 each include the output capacitance 43 of the second amplifier 2 or the fourth amplifier 4, a wire 64, an output line 65, and an output line 66.

An output circuit 60 corresponding to the first output circuit 5 and the third output circuit 7 and an output circuit 61 corresponding to the second output circuit 6 and the fourth output circuit 8 have different electrical lengths within a used frequency, and the electrical length of the output circuit 61 is longer than that of the output circuit 60.

The third embodiment of the present disclosure will be described below in an organized manner.

(3a) In the Doherty amplifier according to the present disclosure, by further having the configuration as described above, it is possible to provide a Doherty amplifier having a configuration different from the configurations of the above-described embodiments and exhibiting effects similar to the above-described effects.

Furthermore, in a case where the Doherty amplifier according to the present disclosure further has configurations similar to those of the above (1a), (1b), (1c), and (1d), similar effects are achieved.

Furthermore, in a case where the Doherty amplifier according to the present disclosure further has a configuration similar to that of the above (1e), similar effects are achieved.

Furthermore, in a case where the Doherty amplifier according to the present disclosure further has a configuration similar to that of the above (2a), similar effects are achieved.

### Fourth Embodiment.

In the first and second embodiments, the Doherty amplifier in which the output circuit includes the output capacitance of the transistor, the output line, and the capacitance has been described, but the output circuit may include a combination of the output capacitance, and a large number of capacitances and output lines. A configuration of an output circuit loaded in a Doherty amplifier according to a fourth embodiment of the present disclosure will be described.

In description of the fourth embodiment, the description of the configuration described in the first embodiment and the configuration described in the second embodiment will be appropriately omitted, and differences from the first embodiment and the second embodiment will be mainly described.

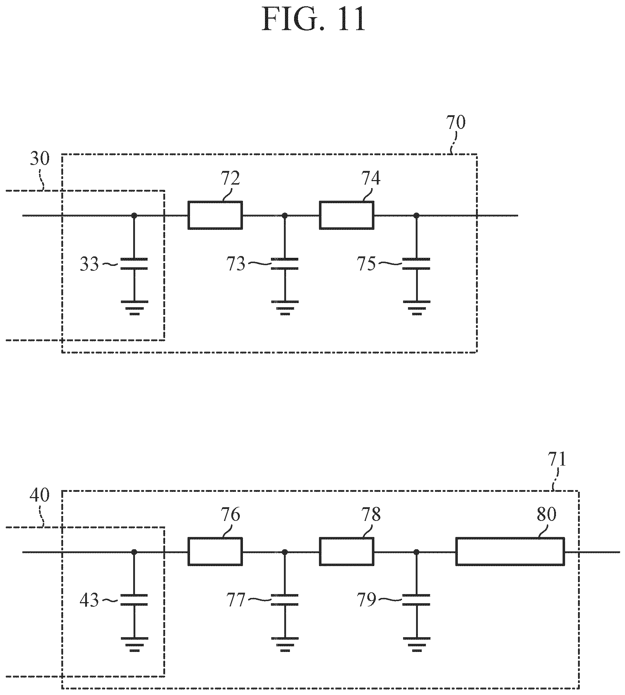

FIG. 11 is a diagram illustrating a configuration of each amplifier of the Doherty amplifier according to the fourth embodiment of the present disclosure.

A configuration of an output circuit loaded in the Doherty amplifier according to the fourth embodiment of the present disclosure will be described.

Specifically, the first output circuit 5 and the third output circuit 7 each include the output capacitance 33 of the first amplifier 1 or the third amplifier 3, an output line 72, a capacitance 73, an output line 74, and a capacitance 75.

The second output circuit 6 and the fourth output circuit 8 each include the output capacitance 43 of the second amplifier 2 or the fourth amplifier 4, an output line 76, a capacitance 77, an output line 78, a capacitance 79, and an output line 80.

An output circuit 70 corresponding to the first output circuit 5 and the third output circuit 7 and an output circuit 71 corresponding to the second output circuit 6 and the fourth output circuit 8 have mutually different electrical lengths within a used frequency, and the electrical length of the output circuit 71 is longer than that of the output circuit 70.

The fourth embodiment of the present disclosure will be described below in an organized manner.

(4a) In the Doherty amplifier according to the present disclosure, by further having the configuration as described above, it is possible to provide a Doherty amplifier having a configuration different from the configurations of the above-described embodiments and exhibiting effects similar to the above-described effects.

Furthermore, in a case where the Doherty amplifier according to the present disclosure further has configurations similar to those of the above (1a), (1b), (1c), and (1d), similar effects are achieved.

Furthermore, in a case where the Doherty amplifier according to the present disclosure further has a configuration similar to that of the above (1e), similar effects are achieved.

Furthermore, in a case where the Doherty amplifier according to the present disclosure further has a configuration similar to that of the above (2a), similar effects are achieved.

### Fifth Embodiment.

In the first and second embodiments, the first output circuit 5, the second output circuit 6, the third output circuit 7, the fourth output circuit 8, the fifth output circuit 11, and the sixth output circuit 12, and the output matching circuit 26 are separated. However, the first output circuit 5, the second output circuit 6, the third output circuit 7, the fourth output circuit 8, the fifth output circuit 11, and the sixth output circuit 12 may have an output matching function, and the output matching circuit 26 may be omitted.

Since a configuration of a Doherty amplifier according to a fifth embodiment is a configuration in which the output matching circuit 26 is omitted from the Doherty amplifier illustrated in FIG. 1 or the Doherty amplifier illustrated in FIG. 9, illustration is omitted.

Each of the first output circuit 5, the second output circuit 6, the third output circuit 7, the fourth output circuit 8, the fifth output circuit 11, and the sixth output circuit 12 has an output matching function.

The fifth embodiment of the present disclosure will be described below in an organized manner.

(5a) In the Doherty amplifier according to the present disclosure, by further having the configuration as described above, it is possible to provide a Doherty amplifier having a configuration different from the configurations of the above-described embodiments and exhibiting effects similar to the above-described effects.

Furthermore, in a case where the Doherty amplifier according to the present disclosure further has configurations similar to those of the above (1a), (1b), (1c), and (1d), similar effects are achieved.

Furthermore, in a case where the Doherty amplifier according to the present disclosure further has a configuration similar to that of the above (1e), similar effects are achieved.

Furthermore, in a case where the Doherty amplifier according to the present disclosure further has a configuration similar to that of the above (2a), similar effects are achieved.

### Sixth Embodiment.

In the first and second embodiments, the gate bias of the first amplifier 1, the gate bias of the second amplifier 2, the gate bias of the third amplifier 3, and the gate bias of the fourth amplifier 4 are set in advance depending on a desired operation. In a sixth embodiment, a mode in which a gate bias is controlled depending on a power level of an input signal will be described.

In description of the sixth embodiment, the description of the configuration described in the first embodiment, the configuration described in the second embodiment, the configuration described in the third embodiment, the configuration described in the fourth embodiment, and the configuration described in the fifth embodiment will be appropriately omitted, and differences from these embodiments will be mainly described.

A configuration example of a Doherty amplifier according to the sixth embodiment of the present disclosure will be described.

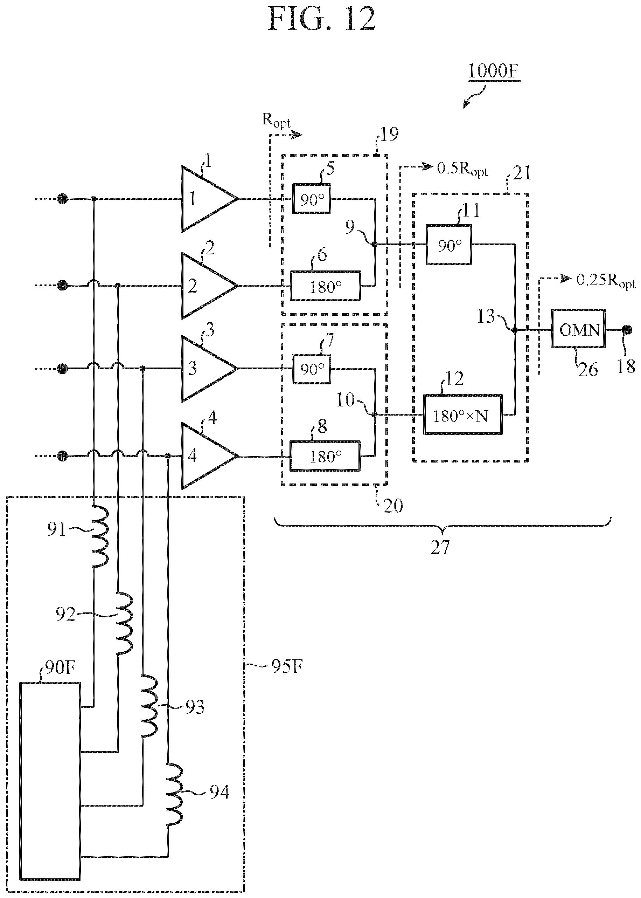

FIG. 12 is a diagram illustrating a configuration of each amplifier of a Doherty amplifier 1000F according to the sixth embodiment of the present disclosure.

The Doherty amplifier 1000F illustrated in FIG. 12 includes a bias control circuit 95F.

The bias control circuit 95F includes a variable power supply 90F, a gate bias circuit 91 to the first amplifier 1, a gate bias circuit 92 to the second amplifier 2, a gate bias circuit 93 to the third amplifier 3, and a gate bias circuit 94 to the fourth amplifier 4.

The bias control circuit 95F acquires an input signal and controls a gate bias to the first amplifier 1, a gate bias to the second amplifier 2, a gate bias to the third amplifier 3, and a gate bias to the fourth amplifier 4 depending on the power level of the input signal.

Specifically, the bias control circuit 95F controls the gate bias to each amplifier by a method such as a so-called envelope tracking method. For example, the bias control circuit 95F acquires the power level of the input signal by reading the input signal by a detector, or acquires the power level of the input signal by receiving information of an envelope from an RF signal source as digital information. The bias control circuit 95F generates a gate voltage from the acquired power level information using, for example, a DC-DC converter following speed of the envelope.

Since the control of the gate bias itself can be implemented by using a known technique, a more detailed description thereof will be omitted here.

In this case, for example, gain of the amplifier that changes depending on the power level of the input signal is smoothed with respect to a change in the power level by controlling the gate bias of each amplifier, whereby distortion can be expected to be reduced.

The sixth embodiment of the present disclosure will be described below in an organized manner.

(6a) The Doherty amplifier according to the present disclosure further includes a bias control circuit to control a gate bias of the first amplifier, a gate bias of the second amplifier, a gate bias of the third amplifier, and a gate bias of the fourth amplifier depending on the power of the input signal.

As a result, in the present disclosure, for example, the gain of the amplifier that changes according to the power level of the input signal can be smoothed with respect to the change in the power level by controlling the gate bias, and the distortion can be reduced.

Furthermore, in a case where the Doherty amplifier according to the present disclosure further has configurations similar to those of the above (1a), (1b), (1c), and (1d), similar effects are achieved.

Furthermore, in a case where the Doherty amplifier according to the present disclosure further has a configuration similar to that of the above (1e), similar effects are achieved.

Furthermore, in a case where the Doherty amplifier according to the present disclosure further has a configuration similar to that of the above (2a), similar effects are achieved.

### Seventh Embodiment.

In the sixth embodiment, the gate bias of the first amplifier 1, the gate bias of the second amplifier 2, the gate bias of the third amplifier 3, and the gate bias of the fourth amplifier 4 are controlled depending on the power level of the input signal, but a drain bias may be controlled depending on the power level of the input signal.

A configuration example of a Doherty amplifier according to a seventh embodiment of the present disclosure will be described.

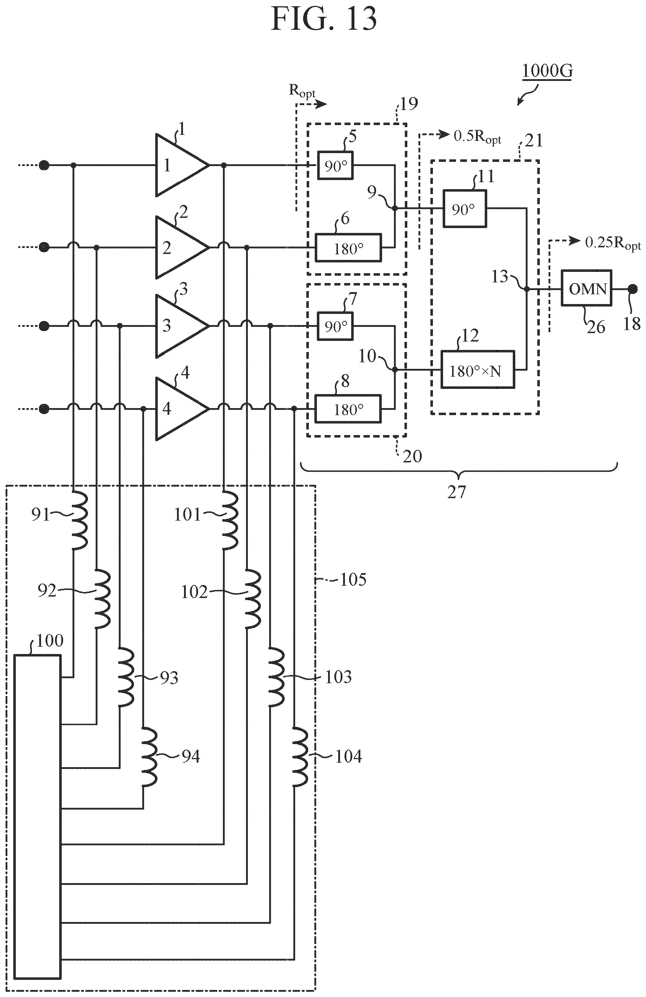

FIG. 13 is a diagram illustrating a configuration of each amplifier of a Doherty amplifier 1000G according to the seventh embodiment of the present disclosure.

The Doherty amplifier 1000G illustrated in FIG. 13 includes a bias control circuit 105.

The bias control circuit 105 includes a variable power supply 100, the gate bias circuit 91 to the first amplifier 1, the gate bias circuit 92 to the second amplifier 2, the gate bias circuit 93 to the third amplifier 3, the gate bias circuit 94 to the fourth amplifier 4, a drain bias circuit 101 to the first amplifier 1, a drain bias circuit 102 to the second amplifier 2, a drain bias circuit 103 to the third amplifier 3, and a drain bias circuit 104 to the fourth amplifier 4.

The bias control circuit 105 acquires an input signal and controls a drain bias to the first amplifier 1, a drain bias to the second amplifier 2, a drain bias to the third amplifier 3, and a drain bias to the fourth amplifier 4 depending on a power level of the input signal.

Specifically, the bias control circuit 105 controls the drain bias to each amplifier by a method such as a so-called envelope tracking method. For example, the bias control circuit 105 acquires the power level of the input signal by reading the input signal by a detector, or acquires the power level of the input signal by receiving information of an envelope from an RF signal source as digital information. The bias control circuit 105 generates a drain voltage from the acquired power level information using, for example, a DC-DC converter following speed of the envelope.

Since the control of the drain bias itself can be implemented by using a known technique, a more detailed description thereof will be omitted here.

In this case, for example, by controlling a drain bias point of the amplifier according to the power level of the input signal, a load is optimized depending on the power level, and high efficiency can be expected.

The seventh embodiment of the present disclosure will be described below in an organized manner.

(7a) The Doherty amplifier according to the present disclosure further includes a bias control circuit to control a drain bias of the first amplifier, a drain bias of the second amplifier, a drain bias of the third amplifier, and a drain bias of the fourth amplifier depending on the power of the input signal.

As a result, in the present disclosure, for example, by controlling the drain bias point of the amplifier according to the power level of the input signal, it is possible to optimize the load depending on the power level, and it is possible to achieve high efficiency.

Furthermore, in a case where the Doherty amplifier according to the present disclosure further has configurations similar to those of the above (1a), (1b), (1c), and (1d), similar effects are achieved.

Furthermore, in a case where the Doherty amplifier according to the present disclosure further has a configuration similar to that of the above (1e), similar effects are achieved.

Furthermore, in a case where the Doherty amplifier according to the present disclosure further has a configuration similar to that of the above (2a), similar effects are achieved.

It is to be noted that the present disclosure can freely combine embodiments, modify any components in the embodiments, or omit any components in the embodiments within the scope of the appended set of claims.

### INDUSTRIAL APPLICABILITY

The Doherty amplifier according to the present disclosure can operate in a wide band corresponding to a plurality of frequency bands, and thus is suitable for use in, for example, an amplifier for a mobile communication base station.

### REFERENCE SIGNS LIST

1: First amplifier, 2: Second amplifier, 3: Third amplifier, 4: Fourth amplifier, 5: First output circuit, 6: Second output circuit, 7: Third output circuit, 8: Fourth output circuit, 9: Combining point of first small branch combining circuit, 10: Combining point of second small branch combining circuit, 11: Fifth output circuit, 12: Sixth output circuit, 13: Combining point of large branch combining circuit, 14: First signal source, 15: Second signal source, 16: Third signal source, 17: Fourth signal source, 18: Output terminal, 19: First small branch combining circuit, 20: Second small branch combining circuit, 21: Large branch combining circuit, 22: First input matching circuit, 23: Second input matching circuit, 24: Third input matching circuit, 25: Fourth input matching circuit, 26: Output matching circuit, 27: Combining circuit, 30: Amplifier, 31: Input capacitance, 32: Current source, 33: Output capacitance, 34: Output circuit, 35: Output line, 36: Capacitance, 40: amplifier, 41: Input capacitance, 42: Current source, 43: Output capacitance, 44: Output circuit, 45: Output line, 46: Capacitance, 47: Output line, 50: First small branch phase adjustment line, 51: Second small branch phase adjustment line, 52: First small branch distribution circuit (First small branched distribution circuit), 53: Second small branch distribution circuit (Second small branched distribution circuit), 54: Large branch phase adjustment line, 55: Large branch distribution circuit (Large branched distribution circuit), 56: Fifth input matching circuit, 57: Input terminal, 58: Distribution circuit, 60: Output circuit, 61: Output circuit, 62: Wire, 63: Output line, 64: Wire, 65: Output line, 66: Output line, 70: Output circuit, 71: Output circuit, 72: Output line, 73: Capacitance, 74: Output line, 75: Capacitance, 76: Output line, 77: Capacitance, 78: Output line, 79: Capacitance, 80: Output line, 90A: Power supply, 90B: Power supply, 90F: Variable power supply, 91: Gate bias circuit to first amplifier, 92: Gate bias circuit to second amplifier, 93: Gate bias circuit to third amplifier, 94: Gate bias circuit to fourth amplifier, 95A: Bias setting circuit, 95B: Bias setting circuit, 95F: Bias control circuit, 100: Variable power supply, 101: Drain bias circuit to first amplifier, 102: Drain bias circuit to second amplifier, 103: Drain bias circuit to third amplifier, 104: drain bias circuit to fourth amplifier, 105: bias control circuit, 1000A, 1000B, 1000F, and 1000G: Doherty amplifier.

## Claims

1. A Doherty amplifier (1000) in which the number of amplifiers contributing to an amplification operation changes depending on power of an input signal, the Doherty amplifier (1000) comprising
at least four or more amplifiers (1, 2, 3, 4); and
a combining circuit (27) to combine outputs of the amplifiers (1, 2, 3, 4), wherein
the amplifiers (1, 2, 3, 4) are connected in parallel with each other,
the amplifiers (1, 2, 3, 4) include a first amplifier (1), a second amplifier (2), a third amplifier (3), and a fourth amplifier (4),
order in which the amplifiers (1, 2, 3, 4) contribute to the amplification operation differs depending on a frequency of the input signal,
the combining circuit (27) includes: a first output circuit (5) connected to an output terminal of the first amplifier (1) and having an electrical length of 90 degrees at a center frequency; a second output circuit (6) connected to an output terminal of the second amplifier (2) and having an electrical length of 180 degrees at the center frequency; a third output circuit (7) connected to an output terminal of the third amplifier (3) and having an electrical length of 90 degrees at the center frequency; and a fourth output circuit (8) connected to an output terminal of the fourth amplifier (4) and having an electrical length of 180 degrees at the center frequency, the amplification operation is performed in such a manner that: at the center frequency, the third amplifier (3) operates when the input signal has low power, the first amplifier (1) joins the operation when the input signal has medium power, and the second amplifier (2) and the fourth amplifier (4) join the operation when the input signal has high power, in a first frequency group, the first amplifier (1) operates when the input signal has low power, the third amplifier (3) joins the operation when the input signal has medium power, and the second amplifier (2) and the fourth amplifier (4) join the operation when the input signal has high power, in a second frequency group, the second amplifier (2) operates when the input signal has low power, the fourth amplifier (4) joins the operation when the input signal has medium power, and the first amplifier (1) and the third amplifier (3) join the operation when the input signal has high power, and in a third frequency group, the fourth amplifier (4) operates when the input signal has low power, the second amplifier (2) joins the operation when the input signal has medium power, and the first amplifier (1) and the third amplifier (3) join the operation when the input signal has high power.

2. The Doherty amplifier (1000) according to claim 1, further comprising a combining circuit (27) that is a combining circuit (27) of a tournament-type that stepwisely combines outputs of the amplifiers (1, 2, 3, 4), the combining circuit (27) having an asymmetric configuration as viewed from each combining nodes.

3. The Doherty amplifier (1000A) according to claim 2, further comprising a plurality of signal sources (14, 15, 16, 17) connected to the amplifiers (1, 2, 3, 4), wherein
biases of the amplifiers (1, 2, 3, 4) are fixed to threshold voltages of the amplifiers, respectively.

4. The Doherty amplifier (1000B) according to claim 2, further comprising:
one signal source;
a distribution circuit (58) to distribute a signal from the signal source to the first amplifier (1), the second amplifier (2), the third amplifier (3), and the fourth amplifier (4); and
a bias setting circuit (95B) to set biases of the first amplifier (1), the second amplifier (2), the third amplifier (3), and the fourth amplifier (4) depending on the power and the frequency of the input signal.

5. The Doherty amplifier (1000A) according to claim 3, wherein
the combining circuit (27) includes:
a first small branch combining circuit (19) to bundle and output an output of the first amplifier (1) and an output of the second amplifier (2);
a second small branch combining circuit (20) to bundle and output an output of the third amplifier (3) and an output of the fourth amplifier (4); and
a large branch combining circuit (21) to bundle and output an output of the first small branch combining circuit (19) and an output of the second small branch combining circuit (20).

6. The Doherty amplifier (1000A) according to claim 5, wherein
the first small branch combining circuit (19) includes:
the first output circuit (5) connected to the first amplifier (1) and having an electrical length of 90 degrees at the center frequency; and
the second output circuit (6) connected to the second amplifier (2) and having an electrical length of 180 degrees at the center frequency, and
the second small branch combining circuit (20) includes:
the third output circuit (7) connected to the third amplifier (3) and having an electrical length of 90 degrees at the center frequency; and
the fourth output circuit (8) connected to the fourth amplifier (4) and having an electrical length of 180 degrees at the center frequency.

7. The Doherty amplifier (1000A) according to claim 6, wherein
the first output circuit (5) is a circuit having a characteristic impedance equal to a load at a time of saturation output of the first amplifier (1),
the second output circuit (6) is a circuit having a characteristic impedance equal to a load at a time of saturation output of the second amplifier (2),
the third output circuit (7) is a circuit having a characteristic impedance equal to a load at a time of saturation output of the third amplifier (3),
the fourth output circuit (8) is a circuit having a characteristic impedance equal to a load at a time of saturation output of the fourth amplifier (4), and
the large branch combining circuit (21) includes a fifth output circuit (11) connected to an output side of the first small branch combining circuit (19) and having a characteristic impedance equal to half of the load at the time of saturation output of the first amplifier (1) and a sixth output circuit (12) connected to an output side of the second small branch combining circuit (20) and having a characteristic impedance equal to half of the load at the time of saturation output of the third amplifier (3).

8. The Doherty amplifier (1000B according to claim 4, wherein
the combining circuit (27) includes:
a first small branch combining circuit (19) to bundle and output an output of the first amplifier (1) and an output of the second amplifier (2);
a second small branch combining circuit (20) to bundle and output an output of the third amplifier (3) and an output of the fourth amplifier (4); and
a large branch combining circuit (21) to bundle and output an output of the first small branch combining circuit (19) and an output of the second small branch combining circuit (20).

9. The Doherty amplifier (1000B) according to claim 8, wherein
the first small branch combining circuit (19) includes:
the first output circuit (5) connected to the first amplifier (1) and having an electrical length of 90 degrees at the center frequency; and
the second output circuit (6) connected to the second amplifier (2) and having an electrical length of 180 degrees at the center frequency, and
the second small branch combining circuit (20) includes:
the third output circuit (7) connected to the third amplifier (3) and having an electrical length of 90 degrees at the center frequency; and
the fourth output circuit (8) connected to the fourth amplifier (4) and having an electrical length of 180 degrees at the center frequency.

10. The Doherty amplifier (1000B) according to claim 9, wherein
the first output circuit (5) is a circuit having a characteristic impedance equal to a load at a time of saturation output of the first amplifier (1),
the second output circuit (6) is a circuit having a characteristic impedance equal to a load at a time of saturation output of the second amplifier (2),
the third output circuit (7) is a circuit having a characteristic impedance equal to a load at a time of saturation output of the third amplifier (3),
the fourth output circuit (8) is a circuit having a characteristic impedance equal to a load at a time of saturation output of the fourth amplifier (4), and
the large branch combining circuit (21) includes a fifth output circuit (11) connected to an output side of the first small branch combining circuit (19) and having a characteristic impedance equal to half of the load at the time of saturation output of the first amplifier (1) and a sixth output circuit (12) connected to an output side of the second small branch combining circuit (20) and having a characteristic impedance equal to half of the load at the time of saturation output of the third amplifier (3).

11. The Doherty amplifier (1000F) according to claim 1, further comprising a bias control circuit (95F) to control a gate bias of the first amplifier (1), a gate bias of the second amplifier (2), a gate bias of the third amplifier (3), and a gate bias of the fourth amplifier (4) depending on the power of the input signal.

12. The Doherty amplifier (1000G) according to claim 1, further comprising a bias control circuit (105) to control a drain bias of the first amplifier (1), a drain bias of the second amplifier (2), a drain bias of the third amplifier (3), and a drain bias of the fourth amplifier (4) depending on the power of the input signal.

## Patentansprüche

1. Doherty-Verstärker (1000), bei dem sich die Anzahl der Verstärker, die zu einem Verstärkungsvorgang beitragen, in Abhängigkeit von der Leistung eines Eingangssignals ändert, wobei der Doherty-Verstärker (1000) umfasst
mindestens vier oder mehr Verstärker (1, 2, 3, 4); und
eine Kombinationsschaltung (27) zum Kombinieren der Ausgänge der Verstärker (1, 2, 3, 4), wobei
die Verstärker (1, 2, 3, 4) parallel zueinander verbunden sind,
die Verstärker (1, 2, 3, 4) einen ersten Verstärker (1), einen zweiten Verstärker (2), einen dritten Verstärker (3) und einen vierten Verstärker (4) aufweisen,
sich die Reihenfolge, in der die Verstärker (1, 2, 3, 4) zum Verstärkungsvorgang beitragen, in Abhängigkeit von der Frequenz des Eingangssignals unterscheidet,
die Kombinationsschaltung (27) aufweist: eine erste Ausgangsschaltung (5), die mit einem Ausgangsanschluss des ersten Verstärkers (1) verbunden ist, und eine elektrische Länge von 90 Grad bei einer Mittenfrequenz aufweist; eine zweite Ausgangsschaltung (6), die mit einem Ausgangsanschluss des zweiten Verstärkers (2) verbunden ist, und eine elektrische Länge von 180 Grad bei der Mittenfrequenz aufweist; eine dritte Ausgangsschaltung (7), die mit einem Ausgangsanschluss des dritten Verstärkers (3) verbunden ist, und eine elektrische Länge von 90 Grad bei der Mittenfrequenz aufweist; und eine vierte Ausgangsschaltung (8), die mit einem Ausgangsanschluss des vierten Verstärkers (4) verbunden ist, und eine elektrische Länge von 180 Grad bei der Mittenfrequenz aufweist, wobei der Verstärkungsvorgang so durchgeführt wird, dass: bei der Mittenfrequenz der dritte Verstärker (3) arbeitet, wenn das Eingangssignal eine niedrige Leistung aufweist, der erste Verstärker (1) sich am Vorgang beteiligt, wenn das Eingangssignal eine mittlere Leistung aufweist, und der zweite Verstärker (2) und der vierte Verstärker (4) sich am Vorgang beteiligen, wenn das Eingangssignal eine hohe Leistung aufweist, in einer ersten Frequenzgruppe der erste Verstärker (1) arbeitet, wenn das Eingangssignal eine niedrige Leistung aufweist, der dritte Verstärker (3) sich am Vorgang beteiligt, wenn das Eingangssignal eine mittlere Leistung aufweist, und der zweite Verstärker (2) und der vierte Verstärker (4) sich am Vorgang beteiligen, wenn das Eingangssignal eine hohe Leistung aufweist, in einer zweiten Frequenzgruppe der zweite Verstärker (2) arbeitet, wenn das Eingangssignal eine niedrige Leistung aufweist, der vierte Verstärker (4) sich am Vorgang beteiligt, wenn das Eingangssignal eine mittlere Leistung aufweist, und der erste Verstärker (1) und der dritte Verstärker (3) sich am Vorgang beteiligen, wenn das Eingangssignal eine hohe Leistung aufweist, und in einer dritten Frequenzgruppe der vierte Verstärker (4) arbeitet, wenn das Eingangssignal eine niedrige Leistung aufweist, der zweite Verstärker (2) sich am Vorgang beteiligt, wenn das Eingangssignal eine mittlere Leistung aufweist, und der erste Verstärker (1) und der dritte Verstärker (3) sich am Vorgang beteiligen, wenn das Eingangssignal eine hohe Leistung aufweist.

2. Doherty-Verstärker (1000) nach Anspruch 1, ferner umfassend eine Kombinationsschaltung (27), bei der es sich um eine Kombinationsschaltung (27) vom Tournament-Typ handelt, die schrittweise Ausgänge der Verstärker (1, 2, 3, 4) kombiniert, wobei die Kombinationsschaltung (27) von jedem Kombinationsknoten aus gesehen eine asymmetrische Konfiguration aufweist.

3. Doherty-Verstärker (1000A) nach Anspruch 2, ferner umfassend eine Vielzahl von Signalquellen (14, 15, 16, 17), die mit den Verstärkern (1, 2, 3, 4) verbunden sind, wobei
Vorspannungen der Verstärker (1, 2, 3, 4) jeweils auf die Schwellenspannungen der Verstärker festgelegt sind.

4. Doherty-Verstärker (1000B) nach Anspruch 2, ferner umfassend:
eine einzelne Signalquelle;
eine Verteilungsschaltung (58) zum Verteilen eines Signals von der Signalquelle an den ersten Verstärker (1), den zweiten Verstärker (2), den dritten Verstärker (3) und den vierten Verstärker (4); und
eine Vorspannungseinstellschaltung (95B) zum Einstellen von Vorspannungen des ersten Verstärkers (1), des zweiten Verstärkers (2), des dritten Verstärkers (3) und des vierten Verstärkers (4) in Abhängigkeit von der Leistung und der Frequenz des Eingangssignals.

5. Doherty-Verstärker (1000A) nach Anspruch 3, wobei
die Kombinationsschaltung (27) aufweist:
eine erste Kleine-Verzweigung-Kombinationsschaltung (19) zum Bündeln und Ausgeben eines Ausgangs des ersten Verstärkers (1) und eines Ausgangs des zweiten Verstärkers (2);
eine zweite Kleine-Verzweigung-Kombinationsschaltung (20) zum Bündeln und Ausgeben eines Ausgangs des dritten Verstärkers (3) und eines Ausgangs des vierten Verstärkers (4); und
eine Große-Verzweigung-Kombinationsschaltung (21) zum Bündeln und Ausgeben eines Ausgangs der ersten Kleine-Verzweigung-Kombinationsschaltung (19) und eines Ausgangs der zweiten Kleine-Verzweigung-Kombinationsschaltung (20).

6. Doherty-Verstärker (1000A) nach Anspruch 5, wobei
die erste Kleine-Verzweigung-Kombinationsschaltung (19) aufweist:
die erste Ausgangsschaltung (5), die mit dem ersten Verstärker (1) verbunden ist, und eine elektrische Länge von 90 Grad bei der Mittenfrequenz aufweist; und
eine zweite Ausgangsschaltung (6), die mit dem zweiten Verstärker (2) verbunden ist, und eine elektrische Länge von 180 Grad bei der Mittenfrequenz aufweist, und
wobei die zweite Kleine-Verzweigung-Kombinationsschaltung (20) aufweist:
die dritte Ausgangsschaltung (7), die mit dem dritten Verstärker (3) verbunden ist, und eine elektrische Länge von 90 Grad bei der Mittenfrequenz aufweist; und
die vierte Ausgangsschaltung (8), die mit dem vierten Verstärker (4) verbunden ist, und eine elektrische Länge von 180 Grad bei der Mittenfrequenz aufweist.

7. Doherty-Verstärker (1000A) nach Anspruch 6, wobei
die erste Ausgangsschaltung (5) eine Schaltung ist, die eine charakteristische Impedanz aufweist, die gleich einer Last zu einem Zeitpunkt des Sättigungsausgangs des ersten Verstärkers (1) ist,
die zweite Ausgangsschaltung (6) eine Schaltung ist, die eine charakteristische Impedanz aufweist, die gleich einer Last zu einem Zeitpunkt des Sättigungsausgangs des zweiten Verstärkers (2) ist,
die dritte Ausgangsschaltung (7) eine Schaltung ist, die eine charakteristische Impedanz aufweist, die gleich einer Last zu einem Zeitpunkt des Sättigungsausgangs des dritten Verstärkers (3) ist,
die vierte Ausgangsschaltung (8) eine Schaltung ist, die eine charakteristische Impedanz aufweist, die gleich einer Last zu einem Zeitpunkt des Sättigungsausgangs des vierten Verstärkers (4) ist, und
die Große-Verzweigung-Kombinationsschaltung (21) eine fünfte Ausgangsschaltung (11), die mit einer Ausgangsseite der ersten Kleine-Verzweigung-Kombinationsschaltung (19) verbunden ist, und eine charakteristische Impedanz, die gleich der Hälfte der Last zum Zeitpunkt des Sättigungsausgangs des ersten Verstärkers (1) ist, und eine sechste Ausgangsschaltung (12), die mit einer Ausgangsseite der zweiten Kleine-Verzweigung-Kombinationsschaltung (20) verbunden ist, und eine charakteristische Impedanz aufweist, die gleich der Hälfte der Last zum Zeitpunkt des Sättigungsausgangs des dritten Verstärkers (3) ist, umfasst.

8. Doherty-Verstärker (1000B) nach Anspruch 4, wobei
die Kombinationsschaltung (27) aufweist:
eine erste Kleine-Verzweigung-Kombinationsschaltung (19) zum Bündeln und Ausgeben eines Ausgangs des ersten Verstärkers (1) und eines Ausgangs des zweiten Verstärkers (2);
eine zweite Kleine-Verzweigung-Kombinationsschaltung (20) zum Bündeln und Ausgeben eines Ausgangs des dritten Verstärkers (3) und eines Ausgangs des vierten Verstärkers (4); und
eine Große-Verzweigung-Kombinationsschaltung (21) zum Bündeln und Ausgeben eines Ausgangs der ersten Kleine-Verzweigung-Kombinationsschaltung (19) und eines Ausgangs der zweiten Kleine-Verzweigung-Kombinationsschaltung (20).

9. Doherty-Verstärker (1000B) nach Anspruch 8, wobei
die erste Kleine-Verzweigung-Kombinationsschaltung (19) aufweist:
die erste Ausgangsschaltung (5), die mit dem ersten Verstärker (1) verbunden ist, und eine elektrische Länge von 90 Grad bei der Mittenfrequenz aufweist; und
eine zweite Ausgangsschaltung (6), die mit dem zweiten Verstärker (2) verbunden ist, und eine elektrische Länge von 180 Grad bei der Mittenfrequenz aufweist, und
wobei die zweite Kleine-Verzweigung-Kombinationsschaltung (20) aufweist:
die dritte Ausgangsschaltung (7), die mit dem dritten Verstärker (3) verbunden ist, und eine elektrische Länge von 90 Grad bei der Mittenfrequenz aufweist; und
die vierte Ausgangsschaltung (8), die mit dem vierten Verstärker (4) verbunden ist, und eine elektrische Länge von 180 Grad bei der Mittenfrequenz aufweist.

10. Doherty-Verstärker (1000B) nach Anspruch 9, wobei
die erste Ausgangsschaltung (5) eine Schaltung ist, die eine charakteristische Impedanz aufweist, die gleich einer Last zu einem Zeitpunkt des Sättigungsausgangs des ersten Verstärkers (1) ist,
die zweite Ausgangsschaltung (6) eine Schaltung ist, die eine charakteristische Impedanz aufweist, die gleich einer Last zu einem Zeitpunkt des Sättigungsausgangs des zweiten Verstärkers (2) ist,
die dritte Ausgangsschaltung (7) eine Schaltung ist, die eine charakteristische Impedanz aufweist, die gleich einer Last zu einem Zeitpunkt des Sättigungsausgangs des dritten Verstärkers (3) ist,
die vierte Ausgangsschaltung (8) eine Schaltung ist, die eine charakteristische Impedanz aufweist, die gleich einer Last zu einem Zeitpunkt des Sättigungsausgangs des vierten Verstärkers (4) ist, und
die Große-Verzweigung-Kombinationsschaltung (21) eine fünfte Ausgangsschaltung (11), die mit einer Ausgangsseite der ersten Kleine-Verzweigung-Kombinationsschaltung (19) verbunden ist, und eine charakteristische Impedanz, die gleich der Hälfte der Last zum Zeitpunkt des Sättigungsausgangs des ersten Verstärkers (1) ist, und eine sechste Ausgangsschaltung (12), die mit einer Ausgangsseite der zweiten Kleine-Verzweigung-Kombinationsschaltung (20) verbunden ist, und eine charakteristische Impedanz aufweist, die gleich der Hälfte der Last zum Zeitpunkt des Sättigungsausgangs des dritten Verstärkers (3) ist, umfasst.

11. Doherty-Verstärker (1000F) nach Anspruch 1, ferner umfassend eine Vorspannungssteuerschaltung (95F) zum Steuern einer Gate-Vorspannung des ersten Verstärkers (1), einer Gate-Vorspannung des zweiten Verstärkers (2), einer Gate-Vorspannung des dritten Verstärkers (3) und einer Gate-Vorspannung des vierten Verstärkers (4) in Abhängigkeit von der Leistung des Eingangssignals.

12. Doherty-Verstärker (1000G) nach Anspruch 1, ferner umfassend eine Vorspannungssteuerschaltung (105) zum Steuern einer Drain-Vorspannung des ersten Verstärkers (1), einer Drain-Vorspannung des zweiten Verstärkers (2), einer Drain-Vorspannung des dritten Verstärkers (3) und einer Drain-Vorspannung des vierten Verstärkers (4) in Abhängigkeit von der Leistung des Eingangssignals.

## Revendications

1. Amplificateur Doherty (1000) dans lequel le nombre d'amplificateurs contribuant à une opération d'amplification change en fonction de la puissance d'un signal d'entrée, l'amplificateur Doherty (1000) comprenant
au moins quatre amplificateurs (1, 2, 3, 4) ou plus ; et
un circuit de combinaison (27) pour combiner des sorties des amplificateurs (1, 2, 3, 4), dans lequel
les amplificateurs (1, 2, 3, 4) sont connectés en parallèle les uns aux autres,
les amplificateurs (1, 2, 3, 4) comprennent un premier amplificateur (1), un deuxième amplificateur (2), un troisième amplificateur (3) et un quatrième amplificateur (4),
l'ordre dans lequel les amplificateurs (1, 2, 3, 4) contribuent à l'opération d'amplification diffère en fonction d'une fréquence du signal d'entrée,
le circuit de combinaison (27) comprend : un premier circuit de sortie (5) connecté à une borne de sortie du premier amplificateur (1) et présentant une longueur électrique de 90 degrés à une fréquence centrale ; un deuxième circuit de sortie (6) connecté à une borne de sortie du deuxième amplificateur (2) et présentant une longueur électrique de 180 degrés à la fréquence centrale ; un troisième circuit de sortie (7) connecté à une borne de sortie du troisième amplificateur (3) et présentant une longueur électrique de 90 degrés à la fréquence centrale ; et un quatrième circuit de sortie (8) connecté à une borne de sortie du quatrième amplificateur (4) et présentant une longueur électrique de 180 degrés à la fréquence centrale, l'opération d'amplification est effectuée de telle manière que : à la fréquence centrale, le troisième amplificateur (3) fonctionne lorsque le signal d'entrée présente une faible puissance, le premier amplificateur (1) se joint à l'opération lorsque le signal d'entrée présente une puissance moyenne, et le deuxième amplificateur (2) et le quatrième amplificateur (4) se joignent à l'opération lorsque le signal d'entrée présente une puissance élevée, dans un premier groupe de fréquences, le premier amplificateur (1) fonctionne lorsque le signal d'entrée présente une puissance faible, le troisième amplificateur (3) se joint à l'opération lorsque le signal d'entrée présente une puissance moyenne, et le deuxième amplificateur (2) et le quatrième amplificateur (4) se joignent à l'opération lorsque le signal d'entrée présente une puissance élevée, dans un deuxième groupe de fréquences, le deuxième amplificateur (2) fonctionne lorsque le signal d'entrée présente une puissance faible, le quatrième amplificateur (4) se joint à l'opération lorsque le signal d'entrée présente une puissance moyenne, et le premier amplificateur (1) et le troisième amplificateur (3) se joignent à l'opération lorsque le signal d'entrée présente une puissance élevée, et dans un troisième groupe de fréquences, le quatrième amplificateur (4) fonctionne lorsque le signal d'entrée présente une puissance faible, le deuxième amplificateur (2) se joint à l'opération lorsque le signal d'entrée présente une puissance moyenne, et le premier amplificateur (1) et le troisième amplificateur (3) se joignent à l'opération lorsque le signal d'entrée présente une puissance élevée.

2. Amplificateur Doherty (1000) selon la revendication 1, comprenant en outre un circuit de combinaison (27) qui est un circuit de combinaison (27) de type tournoi qui combine pas à pas des sorties des amplificateurs (1, 2, 3, 4), le circuit de combinaison (27) présentant une configuration asymétrique lorsqu'il est vu à partir de chaque nœud de combinaison.

3. Amplificateur Doherty (1000A) selon la revendication 2, comprenant en outre une pluralité de sources de signal (14, 15, 16, 17) connectées aux amplificateurs (1, 2, 3, 4), dans lequel
les polarisations des amplificateurs (1, 2, 3, 4) sont fixées à des tensions de seuil des amplificateurs, respectivement.

4. Amplificateur Doherty (1000B) selon la revendication 2, comprenant en outre :
une source de signal ;
un circuit de distribution (58) pour distribuer un signal depuis la source de signal au premier amplificateur (1), au deuxième amplificateur (2), au troisième amplificateur (3) et au quatrième amplificateur (4) ; et
un circuit de réglage de polarisation (95B) pour régler les polarisations du premier amplificateur (1), du deuxième amplificateur (2), du troisième amplificateur (3) et du quatrième amplificateur (4) en fonction de la puissance et de la fréquence du signal d'entrée.

5. Amplificateur Doherty (1000A) selon la revendication 3, dans lequel
le circuit de combinaison (27) inclut :
un premier circuit de combinaison de petite branche (19) pour regrouper et délivrer en sortie une sortie du premier amplificateur (1) et une sortie du deuxième amplificateur (2) ;
un deuxième circuit de combinaison de petite branche (20) pour regrouper et délivrer en sortie une sortie du troisième amplificateur (3) et une sortie du quatrième amplificateur (4) ; et
un circuit de combinaison de grande branche (21) pour regrouper et délivrer en sortie une sortie du premier circuit de combinaison de petite branche (19) et une sortie du deuxième circuit de combinaison de petite branche (20).

6. Amplificateur Doherty (1000A) selon la revendication 5, dans lequel
le premier circuit de combinaison de petite branche (19) inclut :
le premier circuit de sortie (5) connecté au premier amplificateur (1) et présentant une longueur électrique de 90 degrés à la fréquence centrale ; et
le deuxième circuit de sortie (6) connecté au deuxième amplificateur (2) et présentant une longueur électrique de 180 degrés à la fréquence centrale, et
le deuxième circuit de combinaison de petite branche (20) inclut :
le troisième circuit de sortie (7) connecté au troisième amplificateur (3) et présentant une longueur électrique de 90 degrés à la fréquence centrale ; et
le quatrième circuit de sortie (8) connecté au quatrième amplificateur (4) et présentant une longueur électrique de 180 degrés à la fréquence centrale.

7. Amplificateur Doherty (1000A) selon la revendication 6, dans lequel
le premier circuit de sortie (5) est un circuit présentant une impédance caractéristique égale à une charge à un temps de sortie de saturation du premier amplificateur (1),
le deuxième circuit de sortie (6) est un circuit présentant une impédance caractéristique égale à une charge à un temps de sortie de saturation du deuxième amplificateur (2),
le troisième circuit de sortie (7) est un circuit présentant une impédance caractéristique égale à une charge à un temps de sortie de saturation du troisième amplificateur (3),
le quatrième circuit de sortie (8) est un circuit présentant une impédance caractéristique égale à une charge à un temps de sortie de saturation du quatrième amplificateur (4), et
le circuit de combinaison de grande branche (21) comprend un cinquième circuit de sortie (11) connecté à un côté de sortie du premier circuit de combinaison de petite branche (19) et présentant une impédance caractéristique égale à la moitié de la charge au temps de sortie de saturation du premier amplificateur (1) et un sixième circuit de sortie (12) connecté à un côté de sortie du deuxième circuit de combinaison de petite branche (20) et présentant une impédance caractéristique égale à la moitié de la charge au temps de sortie de saturation du troisième amplificateur (3).

8. Amplificateur Doherty (1000B) selon la revendication 4, dans lequel
le circuit de combinaison (27) inclut :
un premier circuit de combinaison de petite branche (19) pour regrouper et délivrer en sortie une sortie du premier amplificateur (1) et une sortie du deuxième amplificateur (2) ;
un deuxième circuit de combinaison de petite branche (20) pour regrouper et délivrer en sortie une sortie du troisième amplificateur (3) et une sortie du quatrième amplificateur (4) ; et
un circuit de combinaison de grande branche (21) pour regrouper et délivrer en sortie une sortie du premier circuit de combinaison de petite branche (19) et une sortie du deuxième circuit de combinaison de petite branche (20).

9. Amplificateur Doherty (1000B) selon la revendication 8, dans lequel
le premier circuit de combinaison de petite branche (19) inclut :
le premier circuit de sortie (5) connecté au premier amplificateur (1) et présentant une longueur électrique de 90 degrés à la fréquence centrale ; et
le deuxième circuit de sortie (6) connecté au deuxième amplificateur (2) et présentant une longueur électrique de 180 degrés à la fréquence centrale, et
le deuxième circuit de combinaison de petite branche (20) inclut :
le troisième circuit de sortie (7) connecté au troisième amplificateur (3) et présentant une longueur électrique de 90 degrés à la fréquence centrale ; et
le quatrième circuit de sortie (8) connecté au quatrième amplificateur (4) et présentant une longueur électrique de 180 degrés à la fréquence centrale.

10. Amplificateur Doherty (1000B) selon la revendication 9, dans lequel
le premier circuit de sortie (5) est un circuit présentant une impédance caractéristique égale à une charge à un temps de sortie de saturation du premier amplificateur (1),
le deuxième circuit de sortie (6) est un circuit présentant une impédance caractéristique égale à une charge à un temps de sortie de saturation du deuxième amplificateur (2),
le troisième circuit de sortie (7) est un circuit présentant une impédance caractéristique égale à une charge à un temps de sortie de saturation du troisième amplificateur (3),
le quatrième circuit de sortie (8) est un circuit présentant une impédance caractéristique égale à une charge à un temps de sortie de saturation du quatrième amplificateur (4), et
le circuit de combinaison de grande branche (21) comprend un cinquième circuit de sortie (11) connecté à un côté de sortie du premier circuit de combinaison de petite branche (19) et présentant une impédance caractéristique égale à la moitié de la charge au temps de sortie de saturation du premier amplificateur (1) et un sixième circuit de sortie (12) connecté à un côté de sortie du deuxième circuit de combinaison de petite branche (20) et présentant une impédance caractéristique égale à la moitié de la charge au temps de sortie de saturation du troisième amplificateur (3).

11. Amplificateur Doherty (1000F) selon la revendication 1, comprenant en outre un circuit de commande de polarisation (95F) pour commander une polarisation de grille du premier amplificateur (1), une polarisation de grille du deuxième amplificateur (2), une polarisation de grille du troisième amplificateur (3), et une polarisation de grille du quatrième amplificateur (4) en fonction de la puissance du signal d'entrée.

12. Amplificateur Doherty (1000G) selon la revendication 1, comprenant en outre un circuit de commande de polarisation (105) pour commander une polarisation de drain du premier amplificateur (1), une polarisation de drain du deuxième amplificateur (2), une polarisation de drain du troisième amplificateur (3) et une polarisation de drain du quatrième amplificateur (4) en fonction de la puissance du signal d'entrée.
